# EUROPEAN PATENT SPECIFICATION

(11) **EP 2 692 526 B1**
(45) Date of publication and mention of the grant of the patent: **28.10.2020**
(21) Application number: 12762807.1
(22) Date of filing: 24.02.2012
(51) Int. Cl.: B32B 15/092, H01L 23/00, C09J 7/20, B32B 27/20

(54) **MULTILAYER RESIN SHEET, RESIN SHEET LAMINATE, CURED MULTILAYER RESIN SHEET AND METHOD FOR PRODUCING SAME, MULTILAYER RESIN SHEET WITH METAL FOIL, AND SEMICONDUCTOR DEVICE**
MEHRLAGIGE HARZPLATTE, HARZPLATTENLAMINAT, GEHÄRTETE MEHRSCHICHTIGE HARZPLATTE UND VERFAHREN ZU IHRER HERSTELLUNG, MEHRSCHICHTIGE HARZPLATTE MIT EINER METALLFOLIE UND HALBLEITERVORRICHTUNG
FEUILLE DE RÉSINE MULTICOUCHE, STRATIFIÉ DE FEUILLE DE RÉSINE, FEUILLE DE RÉSINE MULTICOUCHE DURCIE ET PROCÉDÉ POUR SA PRODUCTION, FEUILLE DE RÉSINE MULTICOUCHE À FEUILLE MÉTALLIQUE ET DISPOSITIF À SEMI-CONDUCTEURS

(30) Priority: 28.03.2011 JP 2011071252
(43) Date of publication of application: 05.02.2014
(73) Proprietor: Hitachi Chemical Company, Ltd., Chiyoda-ku Tokyo 100-6606 (JP)
(72) Inventor: NISHIYAMA, Tomoo, Tsukuba-shi, Ibaraki 300-4247 (JP); KUWANO, Atsushi, Chikusei-shi, Ibaraki 308-8524 (JP); SHIRASAKA, Toshiaki, Chikusei-shi, Ibaraki 308-8521 (JP); AWANO, Yasuhiko, Chikusei-shi, Ibaraki 308-8521 (JP)
(74) Representative: Hoffmann Eitle
(86) International application number: PCT/JP2012/054646
(87) International publication number: WO 2012/132691

(56) References cited:
- WO-A1-2010/024236
- JP-A- 2004 083 602
- JP-A- 2005 281 467
- JP-A- 2007 150 224
- JP-A- 2007 262 398
- JP-A- 2008 153 430
- JP-A- 2008 266 378
- JP-A- 2009 021 530
- JP-A- 2010 258 430
- US-A1- 2008 266 746

## Description

### Technical Field

The invention relates to a multilayer resin sheet, a resin sheet laminate, a cured multilayer resin sheet and a method for producing the same, a multilayer resin sheet with a metal foil, and a semiconductor device.

### Background Art

As electronic devices using a semiconductor decrease in size, increase in capacity and improve in performances, the amount of heat emitted from semiconductor devices, which are highly densely mounted, are growing. For example, it has become necessary to provide a heat sink or a radiation fin to a semiconductor device used for controlling a central processing unit of a personal computer or a motor of an electric vehicle, for the sake of stable operation. Therefore, a material that satisfies both an insulating property and thermal conductivity has been desired for a member that connects a semiconductor device with a heat sink or the like.

Generally, an organic material has been widely used as an insulating material such as a printed circuit board having semiconductor elements or the like mounted thereon. While an organic material is highly insulating, its contribution to radiation for semiconductor devices or the like is not very large due to its low thermal conductivity. On the other hand, there are cases in which an inorganic material, such as inorganic ceramics, is used in for the purpose of radiation for semiconductor devices or the like. While an inorganic material is high in thermal conductivity, its insulating properties are not sufficient as compared with that of an organic material. As such, a material that is highly insulating and thermally conductive has been desired.

In connection with the foregoing, various types of composite materials of a resin and a highly thermally conductive inorganic filler have been studied. For example, a cured product of a composite system of a typical bisphenol A epoxy resin and an alumina filler is known as a material that can achieve a thermal conductivity of 3.8 W/mK as measured by a xenon flash method or 4.5 W/mK as measured by temperature wave analysis (see, for example, Japanese Patent Application Laid-Open (JP-A) No. 2008-13759). Further, a cured product of a composite system of a special epoxy resin, an amine curing agent and an alumina filler is known as a material that can achieve a thermal conductivity of 9.4 W/mK as measured by a xenon flash method or 10.4 W/mK as measured by temperature wave analysis (see, for example, JP-A No. 2008-13759).

As a cured product of a thermosetting resin that is highly thermally conductive, a thermally conductive resin composition that includes boron nitride and polymer components such as an epoxy resin, an amine curing agent and a curing catalyst is known as a material that can achieve a thermal conductivity of from 6 to 11 W/mK as measured by temperature wave analysis (see, for example, JP-A No. 2008-189818).

Further, according to a report concerning a structure of an adhesive layer that is suitable for a power module, occurrence of exfoliation or the like can be suppressed by maintaining the adhesion strength by providing, on at least one side of a first adhesive layer that includes a filler, a second adhesive layer that substantially consists of an adhesive (see, for example, JP-A No. 2009-21530).

### [General Description of the Invention]

### [Problems to be Solved by the Invention]

However, the cured products of a thermally conductive resin described in JP-A No. 2008-13759 and JP-A No. 2008-189818 may have difficulty in satisfying each of thermal conductivity, adhesion strength and insulation properties at high levels. In particular, in a case in which a thermally conductive resin composition includes boron nitride, the adhesion strength of a resin composition layer that includes boron nitride may be insufficient as boron nitride is a soft filler. Further, since boron nitride has a scale-like shape, it tends to behave as a non-Newtonian fluid and makes it difficult to control the resin flowability.

In addition, although JP-A No. 2009-21530 does not describe the properties of the adhesive layer or methods for evaluating the same, it is presumed that the thermal conductivity of the sheet in a thickness direction will significantly decrease due to the absence of a filler in the adhesive layer. It is also presumed that the adhesive strength will decrease because the second adhesive layer is formed of a thermoplastic resin and does not adhere to metal in a chemical manner.

In view of the foregoing, the present invention provides a multilayer resin sheet that exhibits excellent thermal conductivity, adhesion strength and insulating properties; a resin sheet laminate; a cured multilayer resin sheet and a method of producing the same; a multilayer resin sheet with a metal foil; and a semiconductor device.

### [Means for Solving the Problem]

The following are specific means for solving the problems.
<1> A multilayer resin sheet comprising:
   a resin composition layer that comprises a thermosetting resin and a filler; and
   an adhesive layer that is disposed on at least one surface of the resin composition layer, the adhesive layer having an arithmetic average surface roughness Ra of 1.5 µm or less at a surface that does not face the resin composition layer, wherein
   the filler comprises a boron nitride filler,
   the boron nitride filler comprises a boron nitride filler having a volume average particle diameter of from 10 µm to 100 µm,
   the adhesive layer is disposed on a surface of the resin composition layer that has an arithmetic average surface roughness Ra of from 1.5 µm to 4.0 µm, and the adhesive layer has an average thickness of from 6 µm to 15 µm, and
   the resin composition layer comprises the filler of from 40 to 85% by volume in a total solid content of the resin composition layer.
<2> The multilayer resin sheet according to <1>, wherein the resin composition layer comprises, as the thermosetting resin, an epoxy resin monomer and a curing agent.
<3> The multilayer resin sheet according to <1>, wherein a content of the boron nitride filler having a volume average particle diameter of from 10 µm to 100 µm is from 10% by volume to 60% by volume in a total solid content of the resin composition layer.
<4> The multilayer resin sheet according to any one of <1> to <3>, wherein a compression rate of the multilayer resin sheet is 10% or more.
<5> The multilayer resin sheet according to any one of <1> to <4>, wherein the adhesive layer comprises:
   at least one resin selected from the group consisting of an epoxy resin that comprises an acrylic-modified rubber, a modified polyimide resin and a modified polyamideimide resin; and
   an alumina filler.
<6> A cured multilayer resin sheet that is a thermally-treated product of the multilayer resin sheet according to any one of <1> to <5>.
<7> The cured multilayer resin sheet according to <6>, wherein the thermosetting resin forms a cured resin having a high-order structure.
<8> A resin sheet laminate that comprises:
   the multilayer resin sheet according to any one of <1> to <5>; and
   a metal plate or a radiator plate that is disposed on the adhesive layer of the multilayer resin sheet.
<9> A cured resin sheet laminate that is a thermally-treated product of the resin sheet laminate according to <8>.
<10> A method of producing the cured resin sheet laminate according to <9>, the method comprising:
   obtaining a resin sheet laminate by disposing the metal plate or the radiator plate on the adhesive layer of the multilayer resin sheet according to any one of <1> to <5>; and
   curing the resin composition layer by applying heat to the resin sheet laminate.
<11> A multilayer resin sheet with a metal foil, the multilayer resin sheet comprising:
   the multilayer resin sheet according to any one of <1> to <5>; and
   a metal foil that is disposed on the adhesive layer of the multilayer resin sheet.
<12> A semiconductor device that comprises a semiconductor element and the cured multilayer resin sheet according to <6> or <7> disposed on the semiconductor element.

### [Effect of the Invention]

According to the invention, it is possible to provide a multilayer resin sheet that exhibits excellent thermal conductivity, adhesion strength and insulating properties; a resin sheet laminate; a cured multilayer resin sheet and a method of producing the same; a multilayer resin sheet with a metal foil; and a semiconductor device.

### [Brief Description of the Drawings]

Fig. 1 is a graph that illustrates an example of the particle diameter distribution of the filler included in the resin layer of the multilayer resin sheet according to the invention.
Fig. 2 is a graph that illustrates an example of the particle diameter distribution of the filler included in the resin layer of the multilayer resin sheet according to the invention.
Fig. 3 is a schematic cross-section drawing that illustrates an example of the method of producing the multilayer resin sheet according to the invention.
Fig. 4 is a schematic cross-section drawing that illustrates an example of the method of producing the multilayer resin sheet according to the invention.
Fig. 5 is a schematic cross-section drawing that illustrates an example of the method of producing the resin sheet laminate according to the invention.
Fig. 6 is a schematic cross-section drawing that illustrates an example of the cured multilayer resin sheet according to the invention.
Fig. 7 is a schematic cross-section drawing that illustrates an example of a cured multilayer resin sheet that has a similar structure to the cured multilayer resin sheet according to the invention.
Fig. 8 is an example of a cross-section SEM photograph of the cured multilayer resin sheet according to the invention.
Fig. 9 is an example of a cross-section SEM photograph of a cured multilayer resin sheet that has a similar structure to the cured multilayer resin sheet according to the invention.
Fig. 10 is an example of a cross-section SEM photograph of the cured multilayer resin sheet according to the invention.
Fig. 11 is an example of a cross-section SEM photograph of a cured multilayer resin sheet that has a similar structure to the cured multilayer resin sheet according to the invention.
Fig. 12 is a schematic cross-section drawing that illustrates an example of a power semiconductor device having a structure that includes the multilayer resin sheet according to the invention.
Fig. 13 is a schematic cross-section drawing that illustrates an example of a power semiconductor device having a structure that includes the multilayer resin sheet according to the invention.
Fig. 14 is a schematic cross-section drawing that illustrates an example of a power semiconductor device having a structure that includes the multilayer resin sheet according to the invention.
Fig. 15 is a schematic cross-section drawing that illustrates an example of an LED light bar having a structure that includes the multilayer resin sheet according to the invention.
Fig. 16 is a schematic cross-section drawing that illustrates an example of an LED light bulb having a structure that includes the multilayer resin sheet according to the invention.
Fig. 17 is a schematic cross-section drawing that illustrates an example of an LED light bulb having a structure that includes the multilayer resin sheet according to the invention.
Fig. 18 is a schematic cross-section drawing that illustrates an example of an LED light bulb having a structure that includes the multilayer resin sheet according to the invention.

### [Embodiments for Implementing the Invention]

In the present specification, the term "process" refers not only an independent process but also a process that cannot be clearly distinguished from another process, as long as an intended object is achieved.

In the present specification, the numerical value indicated as A to B refers to a range that includes A and B as a minimum value and maximum value, respectively.

In the present specification, when there are plural substances that correspond to each component, the amount of the component in the composition refers to the total amount of the substances that exist in the composition, unless otherwise specified.

### <Multilayer Resin Sheet>

The multilayer resin sheet of the invention includes:
a resin composition layer that includes a thermosetting resin and a filler; and
an adhesive layer that is disposed on at least one surface of the resin composition layer, the adhesive layer having an arithmetic average surface roughness Ra of 1.5 µm or less at a surface that does not face the resin composition layer (hereinafter, also referred to as a "surface"). The multilayer resin sheet may include other layers, as necessary.

The multilayer resin sheet that is provided with, on a resin composition layer, an adhesive layer that has a specific arithmetic average surface roughness exhibits excellent adhesion and insulating properties as compared with a resin sheet that is formed only of a resin composition layer. The cured multilayer resin sheet, which is obtained by curing the resin composition layer of the multilayer resin sheet, exhibits excellent thermal conductivity, adhesion strength and insulating properties. The multilayer resin sheet can be cured by, for example, performing a thermal treatment.

The reasons for the above may be thought to be as follows, for example. By forming the multilayer resin sheet by providing an adhesive layer on a resin composition layer, it enables resin design of the adhesive layer with more consideration to its adhesion strength. Specifically, it becomes possible to use a resin having a strong adhesion strength for the adhesive layer, unlike the case of a resin for the resin composition layer in which thermal conductivity is an important factor.

By forming a multilayer resin sheet by providing an adhesive layer on a resin composition layer, it becomes possible to separate functions such as thermal conductivity or adhesion, and select compositions that are specialized in respective functions. Specifically, it becomes possible to design a resin for an adhesive layer in consideration of adhesion strength, and design a resin for a resin composition layer in consideration of thermal conductivity. In addition, by attaching an adhesive layer to a resin composition layer, the thickness of the resin composition layer at a portion with the least thickness is increased, whereby a dielectric breakdown strength is improved. As a result, by forming a multilayer resin sheet, it is possible to obtain an adhesion strength or a dielectric breakdown strength that are greater than that of the resin composition layer alone.

Further, by having an adhesive layer that has a low elasticity, it becomes easier to release a stress and less prone to exfoliate during a thermal shock test. Moreover, by positioning the resin composition layer, which includes a filler, on the side opposite to the smooth surface of the adhesive layer, it becomes possible to form a rough interface between the resin composition layer and the adhesive layer. In this way, the adhesion strength between the resin composition layer and the adhesive layer is further improved. This is thought to be because of an increase in sticking force due to an anchoring effect or an increase in an area at which the resin composition layer is in contact with the adhesive layer.

The multilayer resin sheet of the invention has an adhesive layer on a surface of at least one side of the resin composition layer, and the adhesive layer may be formed on both sides of the resin composition layer. The adhesive layer may have a support, such as a plastic film, on a surface not facing the resin composition layer. The support may be a support that functions as a protection film. In a case in which the adhesive layer has a support, the arithmetic average surface roughness at a surface of the adhesive layer is measured after removing the support.

The multilayer resin sheet of the invention has an adhesive layer having an arithmetic average surface roughness within a specific range. By having an arithmetic average surface roughness within a specific range, it is thought that the adhesive strength between the adhesive layer and an adherend can be further improved. The adhesive layer of the multilayer resin sheet of the invention has an arithmetic average surface roughness Ra at a surface of 1.5 µm or less. From the viewpoint of adhesion strength and thermal conductivity, the arithmetic average surface roughness Ra at a surface is preferably 1.3 µm or less, more preferably 1.1 µm or less. In a case in which the adhesive layer has an arithmetic average surface roughness at a surface that contacts an adherend is 1.5 µm or less, a strong adhesion with respect to the adherend can be achieved without voids. In a case in which the arithmetic average surface roughness at a surface of the adhesive layer is greater than 1.5 µm, the adhesion strength and the thermal conductivity may decrease. This is thought to be because it becomes easier to include voids between the adhesive layer and the adherend and it becomes difficult to exert adhesion, due to a large surface roughness of the adhesive layer.

The arithmetic average surface roughness at a surface of the adhesive layer is preferably 0.2 µm or more, more preferably 0.4 µm or more. If the surface roughness is too small, expansion of the surface that may occur during a thermal treatment may become significant.

The arithmetic average surface roughness Ra at a surface of the adhesive layer is measured with a surface roughness measuring instrument (for example, a surface roughness measuring instrument manufactured by Kosaka Laboratory Ltd.) with a measurement condition of 1 mm/s and a scanning distance of 50 mm. Specifically, in a case in which a protection film is attached to the multilayer resin sheet, the film is peeled off so that the surface of the multilayer resin sheet is exposed. Then, the multilayer resin sheet is fixed on a measurement table and a measurement needle is placed thereon.

The average thickness of the adhesive layer provided on the resin composition layer is from 6 µm to 15 µm. From the viewpoint of a balance between the thermal conductivity and the adhesive strength, the average thickness is more preferably from 6 µm to 13 µm, particularly preferably from 6 µm to 12 µm.

The arithmetic average surface roughness of the resin composition layer that forms the multilayer resin sheet is from 1.5 µm to 4.0 µm at a surface at which the adhesive layer is to be provided. From the viewpoint of adhesive strength, the arithmetic average surface roughness is preferably from 1.7 µm to 3.5 µm, particularly preferably from 2.0 µm to 3.0 µm.

By imparting roughness to the surface of the resin composition layer such that the arithmetic average surface roughness is from 1.5 µm to 4.0 µm, adhesion strength between the resin composition layer and the adhesive layer is further improved. This is thought to be because of, for example, an increase in sticking force due to an anchoring effect or an increase in an area at which the resin composition layer is in contact with the adhesive layer.

The arithmetic average surface roughness Ra at a surface of the resin composition layer prior to providing the adhesive layer is measured with a surface roughness measuring instrument (for example, a surface roughness measuring instrument manufactured by Kosaka Laboratory Ltd.) with a measurement condition of 1 mm/s.

The arithmetic average surface roughness Ra at a surface of the resin composition layer after providing the adhesive layer thereto can be measured by observation of a cross section of the resin composition layer with an electron scanning microscope and hand calculation. The cross section of the resin composition layer is obtained by protecting the resin composition layer by performing resin embedding, and polishing.

Examples of the method for adjusting the arithmetic average surface roughness at a surface of the resin composition layer include the following methods. Examples of the methods for decreasing the roughness include a method of smoothing the surface by mechanically pressing by flat face pressing, roll pressing or with a laminator, and a method of decreasing the number of large particles during coating by increasing the dispersibility of the resin, filler or the like. Examples of the method for increasing the dispersibility of the resin, filler or the like include selecting a solvent having a strong affinity to the resin, filler or the like. Examples of the method for increasing the roughness include a method of increasing the size or the packing amount of the filler as a raw material, and a method of adding a small amount of a solvent that is low in wettability with respect to the filler.

In the multilayer resin sheet of the invention, the effects as mentioned above tend to be easily achieved if the arithmetic average surface roughness Ra of the resin composition layer at a surface at which the adhesive layer is to be provided is from 1.5 µm to 4.0 µm, and the thickness of the adhesive layer is from 6 µm to 15 µm. This is thought to be as follows, for example.

Specifically, by covering the surface of the resin composition layer with the adhesive layer, the rough surface of the resin composition layer (for example, due to filler) can be smoothed. Further, during attaching the multilayer resin sheet to an adherend such that the adhesive layer is in contact, the adhesive layer is deformed by a pressure applied during attachment and the irregularity of the resin composition layer is filled with the adhesive layer, in addition to attaching the multilayer resin sheet to the adherend. As a result, the thickness of the multilayer resin sheet at a portion with the least thickness is increased and the thickness of the multilayer resin sheet becomes more uniform, whereby a dielectric strength voltage is improved. Therefore, the thickness of the multilayer resin sheet after attaching the same to the adherend tends to be smaller than the thickness of the multilayer resin sheet in a B-stage state (described later) because of an increase in uniformity in thickness and a decrease in void ratio.

The insulation breakdown tends to occur at a portion with the least thickness of the resin composition layer at which electric field concentration tends to occur. Since an electric field to be applied decreases in inverse proportion to the thickness, it is thought that an increase in thickness at a portion with the least thickness with a resin in the adhesive layer makes it difficult to cause insulation breakdown. The effects of improving adhesion or dielectric strength voltage are maintained before or after the curing of the multilayer resin sheet.

### [Resin composition layer]

The resin composition layer includes at least one thermosetting resin, at least one filler, and other components as necessary.

Since the resin composition layer includes a thermosetting resin and a filler, a cured resin layer that is highly thermally conductive (thermally conductive layer) can be formed by curing the resin composition layer by performing a thermal treatment. Further, since the resin composition layer includes a filler, the arithmetic average surface roughness at a surface of the resin composition layer can be readily regulated so as to be within a desired range.

### (Filler)

The thermal conductivity of the resin composition layer is improved by including a filler. There is no particular restriction on the content of a filler in the resin composition layer. From the viewpoints of thermal conductivity and adhesiveness, the content of the filler is from 40% by volume to 85% by volume in the total solid content of the resin composition layer. From a viewpoint of thermal conductivity, the content of the filler is more preferably from 50% by volume to 80% by volume. By including a filler in an amount of from 40% by volume to 85% by volume in the total solid content of the resin composition layer, it is possible to impart roughness to the surface of the resin composition layer that satisfies an arithmetic average surface roughness of from 1.5 to 4.0 µm.

In the specification, the total solid content of the resin composition layer refers to a total content of non-volatile components among the components of the resin composition layer.

It is possible to achieve a remarkable improvement in thermal conductivity by including a boron nitride filler in the resin composition layer. This can be explained, for example, as follows. Boron nitride has a Mohs hardness of 2, which means that boron nitride is softer than other insulation ceramics such as alumina or aluminum nitride (having a hardness of 8, for example). Further, spherical- or round-shaped boron nitride is in the form of an aggregate of primary particles, and cavities exist inside the particle. Therefore, the particle itself tends to deform easily, although it is harder than a molten resin. As the result, the particle can be easily deformed upon application of an external force, during a heat-and-press process, a laminating process, and a pressing process as described later, and a resin can be excluded from the filler as it deforms. Consequently, it becomes easy to bring the fillers close to each other and forms a structure in which fillers having a large particle size including boron nitride are in contact with each other in a continuous manner in the resin composition layer, thereby achieving a significant improvement in thermal conductivity.

In order to confirm whether or not the filler includes boron nitride particles, a technique of directly observing the structure of the resin composition or the sheet with a microscope is effective. For example, it can be confirmed by identifying the crystal form of the filler in the resin composition by observing a cross section of the resin sheet or a cured product thereof with an SEM (scanning electron microscope), and identifying the element of the filler with an SEM-EDX (energy dispersive X-ray spectrometer).

From a viewpoint of thermal conductivity, the volume average particle diameter of the boron nitride filler is from 10 µm to 100 µm; from a viewpoint of insulating properties, it is preferably from 20 µm to 90 µm; and from a viewpoint of adhesiveness, it is further preferably from 30 µm to 80 µm.

From a viewpoint of adhesiveness, the content of the boron nitride filler is preferably from 10% by volume to 60% by volume in the total solid content of the resin composition layer; from a viewpoint of thermal conductivity, it is more preferably from 15% by volume to 55% by volume; and from a viewpoint of insulating properties, it is further preferably from 20% by volume to 50% by volume.

It is particularly preferable that the content of the boron nitride filler having a volume average particle diameter of from 10 µm to 100 µm is from 10% by volume to 60% by volume in the total solid content of the resin composition layer. If the content of the boron nitride filler having a volume average particle diameter of from 10 µm to 100 µm is within the above range, it is preferable from a viewpoint of thermal conductivity.

The volume average particle diameter of the boron nitride filler is preferably from 20 µm to 90 µm, and further preferably from 30 µm to 80 µm.

The content of the boron nitride filler is more preferably from 15% by volume to 55% by volume in the total solid content of the resin composition layer, further preferably from 20% by volume to 50% by volume.

In the resin composition layer another insulating inorganic compound may be included in addition to the boron nitride filler. There is no particular restriction on the content of boron nitride in the filler. From a viewpoint of thermal conductivity, the content of boron nitride in the filler is preferably from 12% by volume to 90% by volume with respect to the total volume of the filler as 100% by volume, more preferably from 20% by volume to 85% by volume.

Further, the resin composition layer may include a filler with a different volume average particle diameter. Specifically, the resin composition layer may include, in addition to a boron nitride filler with a volume average particle diameter of from 10 µm to 100 µm, a filler other than boron nitride with a particle size within the above range or a filler with a particle size below the above range. In order to achieve the closest packing of the fillers, it is also preferable to include fillers having largely different particle sizes. It is also possible to combine three kinds of particles of a large size, a medium size and a small size, respectively.

In a case in which a filler with a particle diameter within the same range as boron nitride is a filler with a large size, the volume average particle diameter thereof is preferably from 10 µm to 100 µm; more preferably from 20 µm to 90 µm from a viewpoint of insulating properties; and especially preferably from 30 µm to 80 µm from the viewpoint of adhesiveness.

The filler with a medium particle size preferably has a volume average particle diameter of from 1 µm to 10 µm; more preferably from 1.5 µm to 8 µm from a viewpoint of resin melt viscosity; and especially preferably from 2 µm to 6 µm from a viewpoint of packing property.

The filler with a small particle size preferably has a volume average particle diameter of from 0.01 µm to 1 µm; more preferably from 0.05 µm to 0.8 µm from a viewpoint of dispersibility; and especially preferably from 0.1 µm to 0.6 µm from a viewpoint of packing properties.

By including at least three kinds of fillers with different volume average particle diameters, the fillers tend to be closely packed and thermal conductivity tends to be improved. Furthermore, when the large filler includes a boron nitride filler, thermal conductivity tends to be further improved.

The volume average particle diameter of a filler is measured by laser diffractometry. The measurement can be performed with a laser diffraction scattering particle size distribution analyzer (e.g., LS230, by Beckman Coulter, Inc.) using a filler that is extracted from the resin composition. Specifically, a filler component is separated from the resin composition by extraction with an organic solvent, nitric acid or aqua regia, and dispersed thoroughly with an ultrasonic wave disperser or the like. By measuring the particle size distribution of the dispersion, the volume average particle diameter of the filler can be measured.

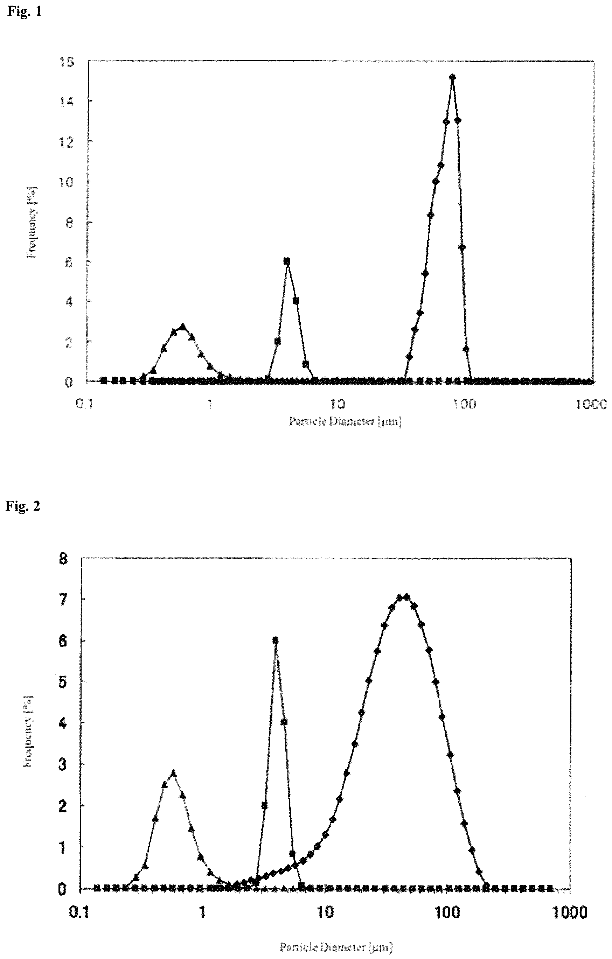

Figs. 1 and 2 show an example of a filler particle size distribution in a case in which the resin composition layer of the multilayer resin sheet includes a filler of large particle size, a filler of medium particle size, and a filler of small particle size. As shown in Figs. 1 and 2, there are peaks of a particle size distribution in a particle diameter range of from 0.01 µm to less than 1 µm, a particle diameter range of from 1 µm to less than 10 µm, and a particle diameter range of from 10 µm to 100 µm, respectively. When the resin composition layer includes fillers having the particle size distribution as described above, the multilayer resin sheet tends to exhibit satisfactory functions such as thermal conductivity and insulating properties.

When the resin composition layer of the multilayer resin sheet includes fillers having a small, medium and large particle diameters, from the viewpoints of thermal conductivity and insulating properties, the ratio of the volume average particle diameter of the medium filler with respect to the volume average particle diameter of the small filler (volume average particle diameter of medium filler / volume average particle diameter of small filler) is preferably from 5 to 50. From the viewpoints of packing properties and thermal conductivity, the ratio is more preferably from 8 to 20.

Further, from the viewpoints of thermal conductivity and insulating properties, the ratio of the volume average particle diameter of the large filler with respect to the volume average particle diameter of the medium filler (volume average particle diameter of large filler / volume average particle diameter of large filler) is preferably from 3 to 40. From the viewpoint of thermal conductivity, the ratio is more preferably from 5 to 30.

When the filler includes a large filler, a medium filler and a small filler, although the filler as a whole preferably has a broad volume average particle size distribution, there is no particular restriction on the particle size distribution. In other words, the filler may have a broad particle size distribution or a narrow particle size distribution. From the viewpoint of thermal conductivity, the filler preferably has a broad particle size distribution that enables a higher packing ratio.

The filler may include a large filler, a medium filler and a small filler as a whole. Specifically, when the particle size distribution of the entire filler is measured, at least three peaks corresponding to a small filler with a volume average particle diameter of from 0.01 µm to less than1 µm, a medium filler with a volume average particle diameter of from 1 µm to less than 10 µm, and a large filler with a volume average particle diameter of from 10 µm to 100 µm, respectively, may be observed.

The filler as mentioned above may be obtained by mixing a large filler, a medium filler and a small filler each showing a single peak in respective particle size distribution, or by using a filler that has two or more peaks in the particle size distribution thereof.

When the resin composition layer of the multilayer resin sheet includes a large filler, a medium filler and a small filler, it is preferred that the content by volume of the small filler in the total volume of the filler is from 1% by volume to 15% by volume, the content of the medium filler in the total volume of the filler is from 10% by volume to 40% by volume, and the content of the large filler in the total volume of the filler is from 45% by volume to 80% by volume. From the viewpoints of packing properties and thermal conductivity, it is more preferred that the content of the small filler in the total volume of the filler is from 6% by volume to 15% by volume, the content of the medium filler in the total volume of the filler is from 18% by volume to 35% by volume, and the content of the large filler in the total volume of the filler is from 50% by volume to 70% by volume.

By setting the content of the large filler as high as possible (for example, from approx. 60% by volume to 70% by volume with respect to the total amount of fillers), and subsequently setting the content of the medium filler as high as possible (for example, from approx. 15% by volume to 30% by volume), the thermal conductivity can be improved more effectively. As described above, by including fillers with different volume average particle diameters, the thermal conductivity can be improved more effectively.

Regarding the combination of the volume average particle diameter and the content of the fillers, it is preferable that the volume average particle diameter of the small filler is from 0.01 µm to less than 1 µm, the volume average particle diameter of the medium filler is from 1 µm to 10 µm, and the volume average particle diameter of the large particle size filler is from 10 µm to 100 µm; and that the volume-based contents are 1% to 15% for the large filler, 10% to 40% for the medium filler, and 45% to 80% for the small filler, respectively.

It is more preferable that the volume average particle diameter of the small filler is from 0.01 µm to 0.6 µm, the volume average particle diameter of the medium filler is from 2 µm to 6 µm, and the volume average particle diameter of the large filler is from 20 µm to 90 µm; and that the volume-based contents with respect to the total filler amount are 6% to 15% for the large filler, 18% to 35% for the medium filler, and 45% to 80% for the small filler, respectively.

From the viewpoints of filler packing properties and thermal conductivity, the volume-based mixture ratio of the small filler and the medium filler is preferably from 1:0.5 to 1:40, more preferably from 1:1 to 1:7.

From the viewpoints of filler packing properties and thermal conductivity, the volume-based mixture ratio of the small filler and the large filler is preferably from 1:3 to 1:80, more preferably from 1:4 to 1:15.

When the large filler includes boron nitride, examples of the insulating inorganic compound other than boron nitride that may be included in the large filler include aluminum oxide, magnesium oxide, boron nitride, aluminum nitride, silicon nitride, talc, mica, aluminum hydroxide, and barium sulfate. Among them, from the viewpoint of thermal conductivity, aluminum oxide, boron nitride, and aluminum nitride are preferable. The material for the filler may be used singly or in combination of two or more kinds.

Although there is no particular restriction on the material for the small filler and the medium filler, a highly thermal conductive material is preferred. Specific examples of the small filler and the medium filler include aluminum oxide, magnesium oxide, boron nitride, aluminum nitride, silicon nitride, talc, mica, aluminum hydroxide, and barium sulfate. Among them, from the viewpoint of thermal conductivity, aluminum oxide, boron nitride, and aluminum nitride are preferable. The material for the filler may be used singly or in combination of two or more kinds.

There is no particular restriction on the particle shape of the filler, and examples thereof include a spherical shape, a round shape, a cataclastic shape, a scaly shape, and an agglomerated particle shape. Among them, from the viewpoints of packing properties and thermal conductivity, a spherical shape and a round shape are preferable.

### (Thermosetting resin)

There is no particular restriction on the thermosetting resin that constitutes the resin composition layer, and a generally used thermosetting resin may be selected and used. From the viewpoints of thermal conductivity and adhesive strength, a thermosetting resin preferably includes at least one kinds of an epoxy resin monomer, more preferably includes at least one kind of an epoxy resin monomer and at least one kind of a curing agent.

### -Epoxy resin monomer-

The resin composition used in the invention includes at least one kind of an epoxy resin monomer (hereinafter, also referred to as an "epoxy resin"). As the epoxy resin, a general epoxy resin may be used without particular restriction. In particular, an epoxy resin monomer that has a low viscosity before curing and exhibits favorable filler packing properties and formability, and has a high thermal conductivity after thermally curing, in addition to a high thermal resistance and a high adhesiveness, is preferable.

When the epoxy resin monomer forms a cured resin together with a novolac resin having a specific structure, a structure with a high crosslinking density originated from a covalent bond or an intermolecular force can be formed in the cured resin. As a result, it is thought that scattering of phonon, which is a vehicle for thermal conduction in an insulating resin, is suppressed, whereby a high thermal conductivity can be achieved.

Specific examples of general epoxy resin include glycidyl ether of bisphenol A, bisphenol F, bisphenol S or bisphenol AD, hydrogenated bisphenol A glycidyl ether, phenol novolac glycidyl ether, cresol novolac glycidyl ether, bisphenol A novolac glycidyl ether, naphthalene glycidyl ether, biphenol glycidyl ether, dihydroxypentadiene glycidyl ether, triphenylmethane epoxy resin, phenol novolac epoxy resin, and cresol novolac epoxy resin.

Preferably, the epoxy resin monomer has a low viscosity before curing and exhibits favorable filler packing properties and formability, and has a high thermal conductivity after thermal curing, in addition to high heat resistance and adhesiveness. For example, an epoxy resin monomer that is in the form of a liquid at 25°C is preferred. Using an epoxy resin monomer as described this, it becomes easier to exhibit flexibility as a sheet or fluidity during laminating. Examples of the epoxy resin monomer that is in the form of a liquid at 25°C include a bisphenol A epoxy resin monomer and a bisphenol AD epoxy resin monomer, a hydrogenated resin thereof, a naphthalene epoxy resin monomer, and a resin having an epoxy group at one end referred to as a reaction diluent. From the viewpoints of a change in elastic modulus in response to the temperature or thermophysical properties after curing, a bisphenol A epoxy resin monomer, a bisphenol AD epoxy resin monomer and a naphthalene epoxy resin monomer are preferable.

The molecular weight of the epoxy resin monomer that is in the form of a liquid at 25°C is not particularly limited. For example, from the viewpoint of fluidity during laminating, the molecular weight is preferably from 100 to 100,000, more preferably from 200 to 50,000, and especially preferably from 300 to 10,000.

In particular, flexibility when the resin composition is made into a sheet or fluidity during laminating can be further improved when at least one type of liquid epoxy resin selected from the group consisting of bisphenol A glycidyl ether and bisphenol F glycidyl ether, having a molecular weight of 5,000 or less, is included.

The epoxy resin monomer may include a multifunctional epoxy resin. In that case, a higher Tg (glass transition temperature) and a higher thermal conductivity can be attained more effectively. As a multifunctional epoxy resin, a phenol novolac epoxy resin, a cresol novolac epoxy resin, a triphenylmethane epoxy resin and the like are favorable.

Further, from the viewpoint of thermal conductivity, an epoxy resin having a mesogenic group may be used. By using an epoxy resin having a mesogenic group, a higher thermal conductivity can be attained. In the specification, the mesogenic group is not particularly limited as long as it can form a high-order structure derived from a mesogenic group in a cured resin when it is formed from an epoxy resin monomer with a curing agent.

The high-order structure refers to a state in which molecules are oriented or aligned in the resin composition after being cured, for example, a state in which a crystal structure or a liquid crystal structure is present in the cured resin. The presence of a crystal structure or a liquid crystal structure can be confirmed in a direct manner by, for example, observing with a polarization microscope with crossed nicols or by X-ray scattering. Further, it can be confirmed in an indirect manner from a decrease in change in storage elastic modulus according to the temperature.

Specific examples of the mesogenic group include a biphenyl group, a terphenyl group, a terphenyl analog, an anthracene group, and a group formed from these groups that are linked via an azomethine group or an ester group.

By forming a cured resin from an epoxy resin monomer having a mesogenic group and a curing agent, a high thermal conductivity may be attained. This can be explained for example as follows. Namely, by forming a cured resin with an epoxy resin monomer having a mesogenic group in the molecule and a curing agent (preferably, a novolac resin as described later), a highly regulated high-order structure that is originated from a mesogenic group can be formed in the cured resin. As the result, it becomes possible to suppress scattering of phonon, which is a vehicle for thermal conduction, in an insulating resin, thereby attaining a high thermal conductivity.

Specific examples of the epoxy resin monomer having a mesogenic group include 4,4'-biphenol glycidyl ether, 1-{(3-methyl-4-oxiranylmethoxy)phenyl}-4-(4-oxiranylmethoxyphenyl)-1-cyclohexene, 4-(oxiranylmethoxy)benzoic acid-1,8-octandiyl bis(oxy-1,4-phenylene) ester, and 2,6-bis[4-[4-[2-(oxiranylmethoxy)ethoxy]phenyl]phenoxy]pyridine. Among them, from the viewpoint of improvement in thermal conductivity, 1-{(3-methyl-4-oxiranylmethoxy)phenyl}-4-(4-oxiranylmethoxyphenyl)-1-cyclohexene is especially preferable.

The epoxy resin may include a liquid epoxy resin. By including a liquid epoxy resin, the resin softening point at stage A or stage B, as described later, can be lowered. More specifically, handleability of a sheet can be improved. However, since a liquid epoxy resin may have a low Tg or a low thermal conductivity, the content of the liquid epoxy resin may be selected appropriately in consideration of the physical properties of a cured resin.

Although there is no particular restriction on the content of the epoxy resin monomer in the resin composition layer, from the viewpoints of thermal conductivity and adhesiveness, it is preferably from 3% by mass to 30% by mass in the total solid content of the resin composition layer. From the viewpoint of thermal conductivity, the content of the epoxy resin monomer in the resin composition layer is more preferably from 4% by mass to 25% by mass, further preferably from 5% by mass to 20% by mass.

### -Curing Agent-

The resin composition layer preferably includes at least one curing agent. The curing agent is not particularly limited as long as it is a compound that can react with an epoxy resin monomer to form a cured resin. Specific examples of the curing agent include polyaddition-type curing agents such as a novolac resin, an aromatic amine curing agent, an aliphatic amine curing agent, a mercaptan curing agent and an acid anhydride curing agent. It is also possible to use a curing catalyst such as imidazole, triphenylphosphine and derivatives thereof having a side chain.

From the viewpoint of thermal conductivity and insulating properties, the resin composition layer preferably includes at least one novolac resin as a curing agent.

The novolac resin is not particularly limited as long as it is a novolac resin that is commonly used as a curing agent for an epoxy resin. From the viewpoint of thermal conductivity and insulating properties, the novolac resin is preferably at least one compound having a structural unit represented by following Formula (I).

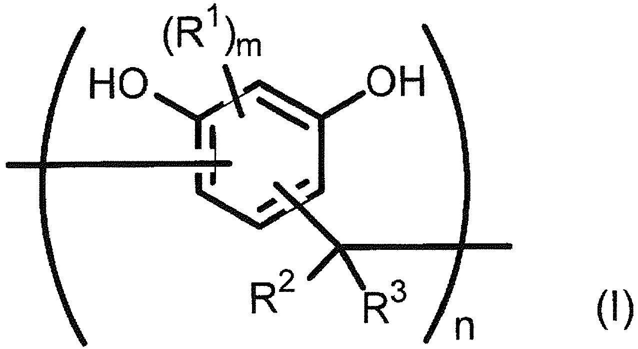

In Formula (I), R¹ represents an alkyl group, an aryl group or an aralkyl group. The alkyl group, the aryl group and the aralkyl group represented by R¹ may have a substituent if possible, and examples of the substituent include an alkyl group, an aryl group, a halogen atom and a hydroxy group.

m represents an integer of 0 to 2, and if m is 2, the two of R¹ may be the same or different from each other. In the invention, m is preferably 0 or 1 from the viewpoint of flowability, more preferably 0 from the viewpoint of thermal conductivity.

The novolac resin preferably includes at least one compound having a structural unit represented by Formula (I). It is also preferred to include two or more compounds having a structural unit represented by Formula (I).

The novolac resin preferably has a partial structure derived from resorcinol as a phenolic compound, but the novolac resin may further include at least one kind of partial structure derived from a phenolic compound other than resorcinol. Examples of the phenolic compounds other than resorcinol include phenol, cresol, catechol, hydroquinone, 1,2,4-trihydroxybenzene and 1,3,5-trihydroxybenzene. The novolac resin may include only one kind of partial structure derived from the compound as described above, or may include two or more kinds of partial structures in combination.

The partial structure derived from a phenolic compound refers to a monovalent or divalent group formed by removing one or two hydrogen atoms from a benzene ring of a phenolic compound. The position from which a hydrogen atom is to be removed is not particularly limited.

From the viewpoint of thermal conductivity, adhesion and storage stability, the partial structure derived from a phenolic compound other than resorcinol is preferably a partial structure derived from at least one selected from the group consisting of phenol, cresol, catechol, hydroquinone, 1,2,3-trihydroxybenzene, 1,2,4-trihydroxybenzene and 1,3,5-trihydroxybenzene; more preferably a partial structure derived from at least one selected from the group consisting of catechol and hydroquinone; further preferably catechol resorcinol novolac resin or hydroquinone resorcinol novolac resin.

In a case in which the novolac resin includes a partial structure derived from resorcinol, the content thereof is not particularly limited. From the viewpoint of thermal conductivity, the content of the partial structure derived from resorcinol with respect to the total mass of the novolac resin is preferably 55% by mass or more, more preferably 80% by mass or more from the viewpoint of achieving an even higher thermal conductivity.

In Formula (I), R² and R³ each independently represent a hydrogen atom, an alkyl group, an aryl group, a phenyl group or an aralkyl group. The alkyl group, the phenyl group and the aralkyl group represented by R² and R³ may have a substituent, if possible. Examples of the substituent include an alkyl group, an aryl group, a halogen atom and a hydroxy group.

The number average molecular weight of the novolac resin is preferably 800 or less from the viewpoint of thermal conductivity, more preferably from 300 to 700 from the viewpoint of resin viscosity, thermal conductivity and glass transition temperature, further preferably from 350 to 550 from the viewpoint of even higher thermal conductivity.

In the resin composition layer, the novolac resin that includes a compound having a structural unit represented by Formula (I) may include a monomer that is a phenolic compound that constitutes a novolac resin. The content of the monomer that is a phenolic compound that constitutes a novolac resin (hereinafter, also referred to as a "monomer content") is not particularly limited, but preferably from 5% by mass to 80% by mass from the viewpoint of moldability, thermal conductivity and glass transition temperature, more preferably from 15% by mass to 60% by mass from the viewpoint of high thermal conductivity and glass transition temperature, further preferably from 20% by mass to 50% by mass from the viewpoint of even higher thermal conductivity and glass transition temperature.

If the novolac resin includes a monomer that is a phenolic compound and the monomer content is 5% by mass or more, an increase in viscosity of the novolac resin tends to be suppressed and adhesion of the filler tends to improve. If the monomer content is 80% by mass or less, a high-order structure with a higher density tends to be formed because of crosslinking reaction during curing, and excellent thermal conductivity and thermal resistance tend to be achieved.

Examples of the monomer that is a phenolic compound that constitutes a novolac resin include resorcinol, catechol and hydroquinone. From the viewpoint of achieving a low melting viscosity prior to curing, a high thermal conductivity after curing and a high crosslinking density, it is preferred to include resorcinol as the monomer.

The content of the curing agent in the resin composition layer is not particularly limited. From the viewpoint of thermal conductivity and adhesion, the content is preferably from 1 to 10% by mass, more preferably from 1 to 8% by mass, in the total solid content of the resin composition layer.

The content of the curing agent in the resin composition layer is also preferably from 0.8 to 1.2, more preferably from 0.9 to 1.1, based on equivalent amount with respect to the epoxy resin monomer.

### (Silane Coupling Agent)

The resin composition layer may include at least one silane coupling agent. By including a silane coupling agent, the resin component including an epoxy resin and a novolac resin and the filler are bonded to each other more favorably, and a higher thermal conductivity and a stronger adhesion can be achieved.

The silane coupling agent is not particularly limited as long as it is a compound that has a functional group that binds to the resin component and a functional group that binds to the filler, and a common silane coupling agent may be used.

Examples of the functional group that binds to the filler include a trialkoxysilyl group such as a trimethoxysilyl group and a triethoxysilyl group. Examples of the functional group that binds to the resin component include an epoxy group, an amino group, a mercapto group, a ureido group and an aminophenyl group.

Specific examples of the silane coupling agent include 3-glycidoxypropyltrimethoxysilane, 3-glycidoxypropyltriethoxysilane, 3-glycidoxypropylmethyldimethoxysilane, 2-(3,4-epoxycyclohexyl)ethyltrimethoxysilane, 3-aminopropyltriethoxysilane, 3-(2-aminoethyl)aminopropyltriethoxysilane, 3-aminopropyltrimethoxysilane, 3-(2-aminoethyl)aminopropyltrimethoxysilane, 3-phenylaminopropyltrimethoxysilane, 3-mercaptotriethoxysilane, and 3-ureidopropyltriethoxysilane.

It is also possible to use a silane coupling agent oligomer, represented by SC-6000KS2, manufactured by Hitachi Chemical Coated Sand. Co., Ltd.

The silane coupling agent may be used singly, or as a combination of two or more kinds.

The content of the silane coupling agent in the resin composition layer is not particularly limited. From the viewpoint of thermal conductivity, the content is preferably from 0.02% by mass to 0.83% by mass, more preferably from 0.04% by mass to 0.42% by mass, in the total solid content of the resin composition layer.

The content of the silane coupling agent with respect to the filler is preferably from 0.02% by mass to 1% by mass from the viewpoint of thermal conductivity, insulation properties and moldability, more preferably from 0.05% by mass to 0.5% by mass from the viewpoint of high thermal conductivity.

### (Other Components)

The resin composition layer may include other components as necessary, in addition to the components as mentioned above. Examples of the other components include an organic solvent, a curing promoter and a dispersant.

### (Method of Preparing Resin Composition Layer)

The method of preparing the resin composition layer is not particularly limited and may be a common method of producing a resin sheet.

For example, the resin composition layer may be prepared by preparing a resin composition by mixing the thermosetting resin (preferably an epoxy resin monomer), curing agent (preferably a novolac resin), filler, other components as necessary and an organic solvent, shaping the resin composition into a sheet, and removing at least a part of the organic solvent.

The organic solvent is not particularly limited, and may be selected appropriately according to purposes. The organic solvent is removed in the drying process during preparation. Since the organic solvent may adversely affect the thermal conductivity or the insulation properties if it remains in a great amount, the organic solvent preferably has a low boiling point or a low vapor pressure. If the organic solvent is removed completely, the resin composition layer may become hardened and adhesion thereof may decrease. Therefore, it is necessary to match the drying method or the drying conditions.

The type of the organic solvent may be selected in view of the resin or the filler, or drying characteristics of the resin composition layer during preparation.

Examples of the type of the organic solvent include alcohol solvents such as methanol, ethanol, 1-propanol, 2-propanol, 1-butanol, 2-propanol and cyclohexanol; ketone solvents such as methyl ethyl ketone, cyclohexanone and cyclopentanone; and amide solvents such as dimethylformamide and dimethylacetamide.

The mixing and dispersing of the components of the resin composition may be performed by combining any of a stirrer, a raikai mixer, a triple roll mill, a ball mill or the like.

The resin composition layer may be prepared by shaping the resin composition into a sheet by, for example, forming a coating layer by applying the resin composition including the filler onto a support, and removing (drying) at least a part of the organic solvent from the coating layer. A support may be provided on one or both sides of the sheet formed from the resin composition layer. By providing a support, the resin composition layer can be protected from adhesion of external matters or from impact shocks.

The average thickness of the resin composition layer may be selected according to purposes. The average thickness of the resin composition layer is preferably smaller from the viewpoint of thermal resistance, but preferably greater from the viewpoint of insulation properties. For example, the average thickness of the resin composition layer may be from 50 µm to 400 µm, preferably from 100 µm to 250 µm, more preferably from 80 µm to 230 µm. The thickness of the resin composition layer can be measured with a micrometer, a contact-type thickness meter, a needle-type thickness meter or the like.

Examples of the support include a plastic film such as a polytetrafluoroethylene film, a polyethylene terephthalate film, a polyethylene film, a polypropylene film, a polymethylpentene film or a polyimide film. As necessary, the film may be subjected to primer coating, UV treatment, corona discharge treatment, polishing, etching or mold-releasing treatment. The support may be a metal support such as a copper foil or an aluminum plate. From the viewpoint of handleability and availability, a polyethylene terephthalate film and a polyimide film are preferred.

When the support is a film, the thickness thereof is not particularly limited and may be determined based on the knowledge of a skilled person based on the thickness of the resin composition layer to be formed or the purposes of the multilayer resin sheet. From the viewpoint of economic efficiency and handleability, the thickness is preferably from 10 µm to 150 µm, more preferably from 20 µm to 120 µm, further preferably from 30 µm to 100 µm, yet further preferably from 40 µm to 80 µm.

The method for applying or drying the resin composition is not particularly limited and a common method may be selected. Examples of the method for application include a method of using a comma coater, a die coater and dip coating. Examples of the method for drying include drying by heating under normal pressure or reduced pressure, natural drying and freeze drying.

The resin composition layer may be a single coating layer formed on a support, or may be formed by performing coating twice or more. Alternatively, the resin composition layer may be formed by attaching a coating layer formed on a support to another coating layer formed on a support.

In the present specification, the multilayer resin sheet having a resin composition layer formed by drying the coating layer may be referred to as an A stage sheet; a multilayer resin sheet obtained by subjecting the resin composition layer to a further heat-and-press treatment may be referred to as a B-stage sheet; and a cured multilayer resin sheet obtained by curing the resin composition layer by performing a further thermal treatment may be referred to as a C-stage sheet.

The B-stage sheet is preferably in a state in which the resin composition is semi-cured (semi-hardened). When the resin composition is semi-cured, handleability is improved. This is because of an increase in elastic modulus and an improvement in strength due to the advanced curing as compared with the A-stage sheet. Meanwhile, the degree of curing of the resin needs to be suppressed so as to maintain its flexibility. The method for allowing the resin composition layer to become a semi-cured B-stage sheet may be, for example, a method of performing heat-and-pressing treatment as described later.

In the present invention, the resin composition layer may be made into a semi-cured state prior (stage B) to providing an adhesive layer, or may be made into a B-stage state after providing an adhesive layer.

The B stage sheet is preferably in a state in which the resin composition is semi-cured. The B stage sheet refers to a resin sheet having a viscosity that decreases by 0.01 to 30% from 10⁴ Pa·s to 10⁷ Pa·s at ordinary temperature (25°C) to from 10² Pa·s to 10⁶ Pa·s at 100°C. The cured resin sheet obtained after curing, as described later, does not melt even if it is heated. The viscosity can be measured by a dynamic viscoelastic measurement (frequency: 1 Hz, load: 40 g, rate of temperature increase: 3°C/minute).

In the present invention, the resin composition layer is preferably made into a cured state (stage C) by performing a thermal treatment to the resin composition layer in a B-stage state, after providing an adhesive layer thereto. The cured resin sheet does not melt even if it is heated. The conditions for a thermal treatment will be described later.

The resin composition layer is preferably obtained by removing at least a part of an organic solvent from the coating layer. More preferably, the resin composition layer is made into a semi-cured state (stage B) by subjecting the coating layer from which at least a part of an organic solvent has been removed to a heat-and-pressing treatment.

The method for subjecting the resin composition layer to a heat-and-pressing treatment is not particularly limited. For example, the treatment can be performed with a hot press machine or a laminator.

The conditions for heat-and-pressing for allowing the resin composition layer to become semi-cured may be selected according to the composition of the resin composition that forms the resin composition layer. For example, the heat-and-pressing treatment may be performed at a temperature of from 60°C to 180°C, a pressure of from 0.1 MPa to 100 MPa, and a time of from 0.1 minutes to 30 minutes.

In a case in which the thermosetting resin included in the resin composition is an epoxy resin, the heat-and-pressing treatment is preferably performed at a temperature of from 60°C to 180°C, a pressure of from 0.1 MPa to 50 MPa, and a time of from 0.1 minutes to 30 minutes, for example. In order to obtain an arithmetic average surface roughness of from 1.5 to 4.0 µm of a resin composition layer in a semi-cured state, the heat-and-pressing treatment is preferably performed at a temperature of from 70°C to 170°C, a pressure of from 0.2 MPa to 30 MPa, and a time of from 0.15 minutes to 10 minutes, for example.

### [Adhesive Layer]

The multilayer resin sheet of the invention has an adhesive layer at least one surface of the resin composition layer. The adhesive layer includes at least one kind of resin that has adhesiveness, and other components such as a filler as necessary.

The adhesive layer is provided at least one surface of the resin composition layer, preferably on both sides of the resin composition layer.

The resin that has adhesiveness is not particularly limited as long as it is a resin that exhibits insulation properties, adhesiveness and flexibility. From the viewpoint of adhesiveness and insulation properties, the resin preferably includes at least one selected from the group consisting of a polyimide resin, a modified polyimide resin, a polyamideimide resin, a modified polyamideimide resin and an epoxy resin, more preferably at least one selected from the group consisting of an epoxy resin including an acrylic modified rubber, a modified polyimide resin and a modified polyamideimide resin.

Examples of the polyimide resin and the modified polyimide resin include the products represented by UPICOAT FS-100L (manufacture by Ube Industries, Ltd.), SEMICOFINE SP-300, SP-400 and SP-800 (manufactured by Toray Industries, Inc.), U IMIDE SERIES (manufactured by Unitika Ltd.) and the like.

Examples of the polyamideimide resin and the modified polyamideimide resin include VYLOMAX series (manufactured by Toyobo Co., Ltd.), TORLON (manufactured by Solvay Advanced Polymers K.K.) and the like. From the viewpoint of high thermal resistance and high adhesion, modified polyamideimide resin represented by KS Series (manufactured by Hitachi Chemical Co., Ltd.) is preferred.

The polyimide resin, polyamideimide resin and modified polyamideimide resin, which are suitably used for the adhesive layer, may be used singly or as a combination of two or more kinds. These resins are usually in the form of a varnish i.e., the resin is dissolved in a solvent, and an adhesive layer may be obtained by forming a film by applying the varnish directly onto a support such as a PET film and removing the solvent by drying.

As the resin having adhesiveness, an epoxy resin, which is a typical thermosetting adhesive resin, may be used. Specifically, for example, the adhesive layer may be formed from an epoxy resin composition that includes an epoxy resin, a curing agent for the epoxy resin, glycidyl acrylate, and a curing promoter. Details of the epoxy resin composition are described in, for example, JP-A No. 2002-134531, JP-A No. 2002-226796 and JP-A No. 2003-221573.

The epoxy resin used for the adhesive layer is not particularly limited as long as it cures and exhibits adhesiveness. In particular, a bisphenol A or bisphenol F liquid-type epoxy resin having a molecular weight of 500 or less is preferred because flowability during stacking can be improved. A polyfunctional epoxy resin may be added in order to increase the Tg (glass transition temperature) and examples of the polyfunctional epoxy resin include a phenol novolac epoxy resin and a cresol novolac epoxy resin.

The curing agent for the epoxy resin may be selected from those commonly used as a curing agent for an epoxy resin. Examples include polyamide, polyamine, acid anhydride, phenol novolac resin, polysulfide, boron trifluoride and a compound having two or more phenolic hydroxy group such as bisphenol A, bisphenol F or bisphenol S. From the viewpoint of excellent electric corrosion resistance upon absorption of moisture, a phenol resin such as a phenol novolac resin, a bisphenol novolac resin or a cresol novolac resin is preferred.

When using a curing agent, a curing accelerator is preferably used together with the curing agent. As the curing accelerator, imidazole is preferred. Examples of imidazole include 2-methylimidazole, 2-ethyl-4-methylimidazole, 1-cyanoethyl-2-phenylimidazole and 1-cyanoethyl-2-phenylimidazolium trimelitate. The imidazole compounds are available under the trade names of, for example, 2E4MZ, 2PZ-CN and 2PZ-CNS, from Shikoku Chemicals Corporation.

The epoxy resin used for the adhesive layer is preferably a high-molecular-weight epoxy resin that includes a high-molecular-weight resin that is compatible with an epoxy resin.

Examples of the high-molecular-weight resin that is compatible with an epoxy resin include a high-molecular-weight epoxy resin, a rubber having a highly-polar functional group, and a reactive rubber having a highly polar functional group.

Examples of the reactive rubber having a highly polar functional group include an acrylic-modified rubber that is added with a highly polar functional group such as a carboxyl group.

The term "compatible with an epoxy resin" refers to a characteristic of forming a homogeneous mixture without separating from the epoxy resin to form two or more phases after curing.

The weight average molecular weight of the high-molecular-weight resin is not particularly limited. From the viewpoint of reducing the tackiness of the adhesive in a state of B stage or improving plasticity upon curing, the weight average molecular weight is preferably 30,000 or more.

Examples of the high-molecular-weight epoxy resin include high-molecular-weight epoxy resin having a molecular weight of from 30,000 to 80,000 and a super high-molecular-weight epoxy resin having a molecular weight of over 80,000 (refer to Japanese Published Examined Application Nos. H07-56917, H07-59618, H07-59619, H07-059620, H07-64911 and H07-68327), which are manufactured by Hitachi Chemical Co., Ltd. As for the reactive rubber having a highly polar functional group, a carboxyl group-containing acrylic rubber is available from Nagase ChemteX Corporation under the trade name of HTR-860P.

When a high-molecular-weight resin that is compatible with an epoxy resin and has a weight average molecular weight of 30,000 or more is used, the amount thereof is preferably 10 parts by mass or more, and preferably 40 parts by mass or less, when the resin that constitutes the adhesive layer is 100 parts by mass.

When the amount is 10 parts by mass or more, it is possible to prevent insufficiency in plasticity of a phase having an epoxy resin as a main component (hereinafter, referred to as an epoxy resin phase), reduction in tackiness or reduction in insulation properties due to cracking or the like. When the amount of 40 parts by weight or less, it is possible to prevent reduction in Tg of the epoxy resin phase.

The weight average molecular weight of the high-molecular-weight epoxy resin is preferably from 20,000 to 500,000. Within this range, it is possible to suppress a reduction in strength or plasticity in the form of a sheet or a film, and suppress an increase in tackiness.

The polyamideimide resin, modified polyamideimide resin or epoxy resin, suitably used for the adhesive layer, may be used singly or as a combination of two or more kinds.

These resins are usually in the form of a varnish i.e., the resin is dissolved in a solvent, and an adhesive layer may be obtained by forming a film by applying the varnish directly onto a support such as a PET film and removing the solvent by drying.

### (Silane Coupling Agent)

The adhesive layer may include a silane coupling agent in order to improve interfacial bonding between different materials. Specific examples of the silane coupling agent include γ-glycidoxypropyl trimethoxysilane, γ-mercaptopropyl trimethoxysilane, γ-aminopropyl triethoxysilane, γ-ureidopropyl triethoxysilane, and N-β-aminoethyl-γ-aminopropyl trimethoxysilane. From the viewpoint of adhesion strength, γ-mercaptopropyl trimethoxysilane and y-aminopropyl triethoxysilane are preferred. When the adhesive layer includes a silane coupling agent, the amount thereof is preferably from 0.1 parts by mass to 10 parts by mass with respect to 100 parts by mass of the resin that constitutes the adhesive layer, from the viewpoint of an effect of adding the silane coupling agent or thermal resistance.

### (Filler)

The adhesive layer preferably includes at least one filler, more preferably at least one inorganic filler. By including the filler, handleability or thermal conductivity of the adhesive layer is improved. Further, it becomes possible to impart inflammability, adjust melting viscosity, impart thixotropy or improve surface hardness.

When the adhesive layer includes a filler, the content thereof is not particularly limited. Preferably, the content is from 20 parts by volume to 50 parts by volume with respect to 100 parts by volume of the resin component included in the adhesive layer. From the viewpoint of effect of adding the filler, the amount thereof is preferably 30 parts by volume or more. From the viewpoint of suppressing an increase in storage elasticity, a decrease in adhesiveness, a decrease in insulating properties due to remaining voids or the like, the amount of the filler is also preferably 50 parts by volume or less.

Examples of the inorganic filler include aluminum hydroxide, magnesium hydroxide, calcium carbonate, magnesium carbonate, calcium silicate, magnesium silicate, calcium oxide, magnesium oxide, alumina powder, aluminum nitride powder, boron aluminum whisker, boron nitride powder, crystalline silica, amorphous silica, silicon nitride, talc, mica and barium sulfate. Among these, alumina, boron nitride and aluminum nitride exhibit favorable heat releasing properties due to high thermal conductivity, and the amount of impurity included therein is small. Therefore, these fillers are suitable in view of favorable thermal resistance and insulation properties. The filler may be used singly or as a combination of two or more kinds.

The volume average particle diameter of the filler included in the adhesive layer is not particularly limited. For example, from the viewpoint of thermal conductivity, the volume average particle diameter is preferably from 0.1 µm to 10 µm, more preferably from 0.5 µm to 5 µm.

When an adhesive layer that is made into a film by the method as described later, the content of the filler in the adhesive layer is preferably 50% by volume or less from the viewpoint of the balance between adhesion and thermal conductivity. From the viewpoint of thermal conductivity, the content of the filler is preferably from 20% by volume to 50% by volume.

In particular, from the viewpoint of adhesion strength and thermal conductivity, the adhesive layer preferably includes at least one selected from an epoxy resin that includes acrylic-modified rubber and a modified polyamideimide resin as a resin having adhesiveness, and at least one selected from alumina and silica as a filler, wherein the content of the filler is from 25 parts by volume to 100 parts by volume with respect to 100 parts by volume of the resin component, and the volume average particle diameter of the filler is from 0.5 µm to 5 µm.

From the viewpoint of thermal conductivity and adhesion, the average thickness of the adhesive layer is preferably from 3 µm to 16 µm, more preferably from 4 µm to 15 µm, further preferably from 5 µm to 14 µm, yet further preferably from 6 µm to 12 µm. The thickness of the adhesive layer can be measured with a micrometer, a contact-type thickness meter, a needle-type thickness meter or the like.

### <Method of Producing Multilayer Resin Sheet>

The method of producing the multilayer resin sheet of the invention includes:
obtaining a resin composition layer that includes a thermosetting resin and a filler; and
disposing an adhesive layer on at least one surface of the resin composition layer, the adhesive layer having an arithmetic average surface roughness Ra of 1.5 µm or less at a surface that does not face the resin composition layer.

Examples of the method of forming an adhesive layer on a resin composition layer include a method of attaching an adhesive layer that has been prepared into a film to a resin composition layer, and a method of forming an adhesive layer on a resin composition layer by directly applying a varnish for forming the adhesive layer to a surface of the resin composition layer and removing the solvent by drying.

In the invention, from the viewpoint of workability or the like, a method of preparing an adhesive layer in the form of a film and attaching the same to a resin composition layer is preferred.

The adhesive layer in the form of a film is obtained by, for example, preparing a varnish for forming an adhesive layer by dissolving or dispersing the components that constitutes the adhesive layer in a solvent, applying the varnish onto a support to form a coating layer, and removing the solvent from the coating layer by heating to form the adhesive layer on the support. The support also provides protection for the surface of the adhesive layer.

Specific examples of the support include a plastic film such as a polytetrafluoroethylene film, a polyethylene terephthalate film, a polyethylene terephthalate film that has been subjected to a mold releasing treatment, and a polyimide film.

Example of the method of providing an adhesive layer in the form of a film onto a resin composition layer include a method of performing heating and pressing by a flat press method or a roll press method. Specific examples of the method include a method of subjecting a layered structure in which an adhesive layer in the form of a film is placed on the resin composition layer to a laminate treatment with a hot pressing machine or a laminator.

The heating and pressing is preferably performed at a temperature of from 60°C to 220°C, a pressure of from 0.1 MPa to 100 MPa, and a time of from 0.1 minutes to 60 minutes, for example. More preferably, the heating and pressing is performed at a temperature of from 80°C to 180°C, a pressure of from 0.2 MPa to 80 MPa, and a time of from 0.15 minutes to 30 minutes.

The process of obtaining the multilayer resin sheet can be performed under atmospheric pressure (normal pressure), but preferably performed under reduced pressure. Specifically, the process is preferably performed at 30,000 Pa or less, more preferably at 5,000 Pa or less. In that case, a sheet that exhibits excellent adhesion strength, thermal conductivity and dielectric breakdown voltage can be obtained.

The method of producing the multilayer resin sheet of the invention includes a process of allowing at least a part of a filler having a large diameter (large filler), which is included in the resin composition layer, to be embedded in the adhesive layer. The multilayer resin sheet obtained by a method including the process as mentioned above has a structure in which at least a part of a large filler in the resin composition layer is embedded in the adhesive layer, prior to attaching the multilayer resin sheet to an adherend. Therefore, it is possible to suppress resin flow during attaching and reduce a pressure to be applied for attaching, thereby suppressing deformation of the adherend.

Example of the method of allowing the large filler in the resin composition layer to be embedded in the adhesive layer include a method of performing a heat-and-press treatment after forming the adhesive layer on the resin composition layer. Specifically, the method can be performed with a vacuum heating press machine, a laminator, a rubber heating roll, a metal heating roll or the like.

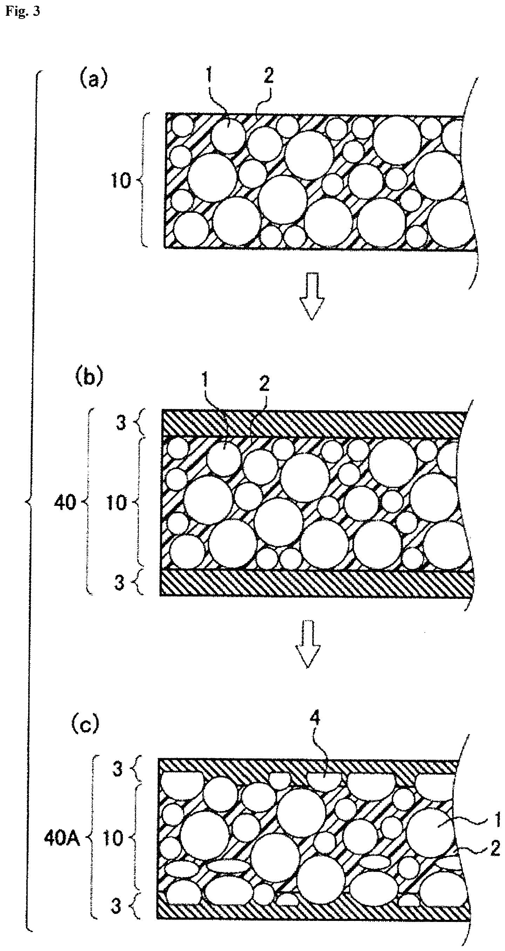

The following are explanation with reference to the drawings illustrating an example of the method for producing a multilayer resin sheet that includes a process of allowing at least a part of a large filler in the resin composition layer to be embedded in the adhesive layer. In Fig. 3(a), as described above, resin composition layer 10 that includes a thermosetting resin and filler 1, which includes a large filler having a volume average particle diameter of from 10 µm to 100 µm, is obtained. Subsequently, as shown in Fig. 3(b), adhesive layers 3 are disposed on both sides of resin composition layer 10. The method of forming adhesive layer 3 is as described above. Subsequently, resin sheet 40, having a structure in which adhesive layers 3 are disposed on both sides of resin composition layer 10, is subjected to a heat-and-press treatment with a vacuum heating press machine, a metal heating roll or the like, whereby a part of the filler in resin composition layer 10 is embedded in adhesive layer 3. Multilayer resin sheet 40A, in which filler 4 is embedded in adhesive layer 3 as shown in Fig. 3(c), is thus produced.

In the method of producing the multilayer resin sheet, a process of positioning an adhesive layer on at least on surface of a resin composition layer may be performed at the same time as a process of allowing at least a part of a large filler to be embedded in the adhesive layer.

Specifically, the process of positioning the adhesive layer on the resin composition layer may be performed at a temperature of from 80°C to 220°C, a pressure of from 1 MPa to 100 MPa and a time of from 0.1 minutes to 60 minutes, so that at least a part of the large filler is embedded in the adhesive layer. The conditions for the heating and pressing is preferably a temperature of from 100°C to 200°C, a pressure of from 1.5 MPa to 80 MPa and a time of from 0.3 minutes to 40 minutes. These conditions are more preferably determined in consideration of the pressing process to be described later.

The heating and pressing can be performed under atmospheric pressure (normal pressure), but preferably performed under reduced pressure. Specifically, the process is performed at 30,000 Pa or less, more preferably at 10,000 Pa or less.

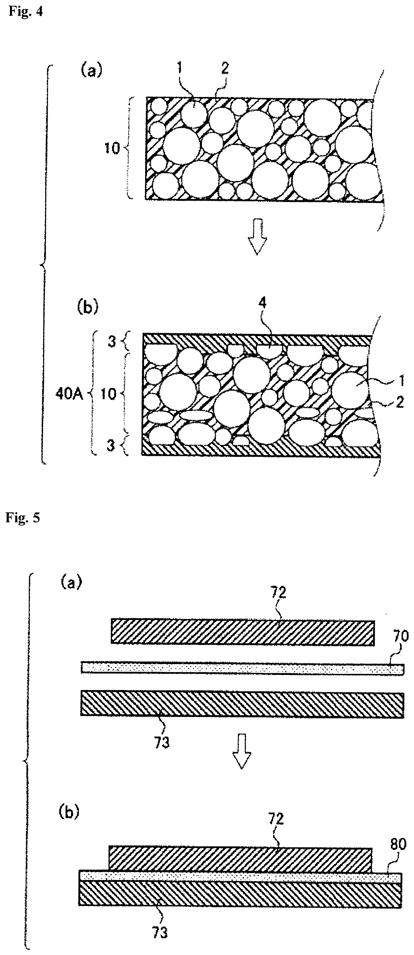

The following are explanation with reference to the drawings of an example of the method of producing the multilayer resin sheet, in which a process of positioning an adhesive layer on at least on surface of a resin composition layer is performed at the same time as a process of allowing at least a part of a large filler to be embedded in the adhesive layer. In Fig. 4(a), as described above, resin composition layer 10 that includes a thermosetting resin and filler 1, which includes a large filler having a volume average particle diameter of from 10 µm to 100 µm, is obtained. Subsequently, adhesive layers 3 are formed on both sides of resin composition layer 10 and a part of the filler in resin composition layer 10 is embedded in adhesive layers 3, by controlling the conditions for heating and pressing. In this way, multilayer resin sheet 40A, in which filler 4 is embedded in adhesive layer 3 as shown in Fig. 4(b), is obtained.

### <Method of Using Multilayer Resin Sheet>

The multilayer resin sheet of the invention can be used as follows. For example, in a case of a multilayer resin sheet in which an adhesive layer is formed on one surface of a resin composition layer, a laminate can be obtained by positioning the multilayer resin sheet such that the adhesive layer side of the multilayer resin sheet faces an adherend such as a metal plate, and performing a heat-and-press treatment (laminate formation process). The laminate may be obtained by using a multilayer resin sheet in which a resin composition layer includes a large filler having a volume average particle diameter of from 10 µm to 100 µm.

The laminate can be cured by further performing a heat-and-press treatment (curing process). The conditions for the heat-and-press treatment in the curing process are not particularly limited as long as the resin composition layer is cured. For example, the treatment is preferably performed at a temperature of from 80°C to 250°C, a pressure of from 1 MPa to 100 MPa and a time of from 0.1 minutes to 360 minutes; more preferably at a temperature of from 100°C to 220°C, a pressure of from 1.5 MPa to 80 MPa and a time of from 10 minutes to 240 minutes.

The curing process can be performed under atmospheric pressure (normal pressure), but preferably performed under reduced pressure. Specifically, the process is performed at 30,000 Pa or less, more preferably at 10,000 Pa or less.

It is possible to further improve thermal conductivity and thermal resistance of the laminate by further performing a thermal treatment after the curing process. The thermal treatment may be performed at a temperature of from 100°C to 250°C for a time of from 10 minutes to 300 minutes, for example. From the viewpoint of thermal conductivity, the thermosetting resin preferably includes an epoxy resin having a mesogenic structure and the thermal treatment is preferably performed at a temperature at which the epoxy resin having a mesogenic structure tends to be oriented. In particular, the thermal treatment is preferably performed in at least two steps of from 100°C to 160°C and from 160°C to 250°C, more preferably at least three steps of from 100°C to less than 150°C, from 150°C to less than 180°C and from 180°C to 220°C.

In a case of using a multilayer resin sheet in which a resin composition includes a large filler and at least a part of the large filler is embedded in an adhesive layer, the conditions for heating and pressing during the lamination formation process are not particularly limited. For example, the condition are preferably a temperature of from 60°C to 200°C, a pressure of from 0.5 MPa to 100 MPa and a time of from 0.1 minutes to 360 minutes. From the viewpoint of retaining thermal conductivity, the conditions are preferably a temperature of from 80°C to 180°C, a pressure of from 1 MPa to 30 MPa and a time of from 0.5 minutes to 240 minutes.

In a case of using a multilayer resin sheet in which a resin composition includes a large filler and at least a part of the large filler is not embedded in an adhesive layer, a heat-and-press treatment in order to allow the large filler in the resin composition layer to be embedded in the adhesive layer is preferably performed. In that case, the conditions for the heat-and-press treatment are preferably a temperature of from 60°C to 200°C, a pressure of from 0.5 MPa to 200 MPa and a time of from 0.1 minutes to 360 minutes, more preferably a temperature of from 80°C to 180°C, a pressure of from 1 MPa to 100 MPa and a time of from 0.5 minutes to 240 minutes. By performing the heat-and-press treatment, a multilayer resin sheet laminate in which at least a part of the large filler in the resin composition layer is embedded in the adhesive layer can be obtained.

The conditions for the heating and pressing in the lamination formation process are not particularly limited. For example, the conditions are preferably a temperature of from 60°C to 240°C, a pressure of from 0.5 MPa to 200 MPa and a time of from 0.1 minutes to 360 minutes, more preferably a temperature of from 70°C to 220°C, a pressure of from 1 MPa to 100 MPa and a time of from 0.5 minutes to 240 minutes.

In the lamination formation process, at least a part of the large filler in the resin composition layer may be embedded in the adhesive layer at the same time as the lamination formation process, In that case, the conditions for heating and pressing are preferably a temperature of from 60°C to 200°C, a pressure of from 1.5 MPa to 100 MPa and a time of from 0.1 minutes to 360 minutes, more preferably a temperature of from 80°C to 180°C, a pressure of from 2 MPa to 80 MPa and a time of from 0.5 minutes to 240 minutes. From the viewpoint of reducing the number of processes, a method of allowing at least a part of the large filler in the resin composition layer to be embedded in the adhesive layer at the same time as the lamination formation process is preferred.

The multilayer resin sheet may have adherends at both sides thereof even when an adhesive layer is formed only on one side. Alternatively, the multilayer resin sheet may have adherends at both sides thereof even when an adhesive layer is formed on both sides. An example of the lamination formation process is described with reference to the drawings. As shown in Fig. 5(a), first adherend 72, multilayer resin sheet 80 and second adherend 73 are layered in this order, and heated and pressed such that multilayer resin sheet 70 is sandwiched between first adherend 72 and second adherend 73. A laminate having a structure in which first adherend 72, multilayer resin sheet 70 and second adherend 73 are laminated in this order, as shown in Fig. 5(b), is thus obtained.

The adherend is not particularly limited, and examples thereof include metals such as copper, aluminum, copper-chromium alloy and nickel-plated metal plate; resins such as polyimide, epoxy, triazine, melamine, nylon and ABS; ceramics such as alumina, boron nitride, magnesium oxide, silicon nitride and aluminum nitride; and composite materials such as a mixture of these materials.

The multilayer resin sheet of the invention has a high thermal conductivity and is capable of forming a highly thermo-conductive cured multilayer resin sheet that can withstand a severe thermal impact that may be applied during mounting, driving or the like. Therefore, the multilayer resin sheet of the invention is expected to expand in applications in which demand is expected to increasingly grow, such as radiation materials for an inverter for hybrid automobiles, an inverter for industrial instruments, and LEDs.

### <Cured Multilayer Resin Sheet>

The cured multilayer resin sheet of the invention is a thermally-treated product of a multilayer resin sheet, the multilayer resin sheet including:
a resin composition layer that comprises a thermosetting resin and a filler; and
an adhesive layer that is disposed on at least one surface of the resin composition layer, the adhesive layer having an arithmetic average surface roughness Ra of 1.5 µm or less at a surface that does not face the resin composition layer.

The thermosetting resin preferably forms a cured resin that has a high-order structure.

The cured multilayer resin sheet of the invention does not significantly change in thermal conductivity before and after the curing, even with the existence of resin of the adhesive layer at the surface. The reason is thought to be as follows. When the multilayer resin sheet is attached to an adherend such that the adhesive layer faces the adherend, the adhesive layer deforms and the resin in the adhesive layer enters concave portions of the resin composition layer, and the thickness of the adhesive layer is reduced. As a result, the distance between the resin composition layer and the adherend is decreased, thereby making it easier to form a thermal conduction path. By curing the multilayer resin sheet of this state, it is thought that thermal conductivity is improved.

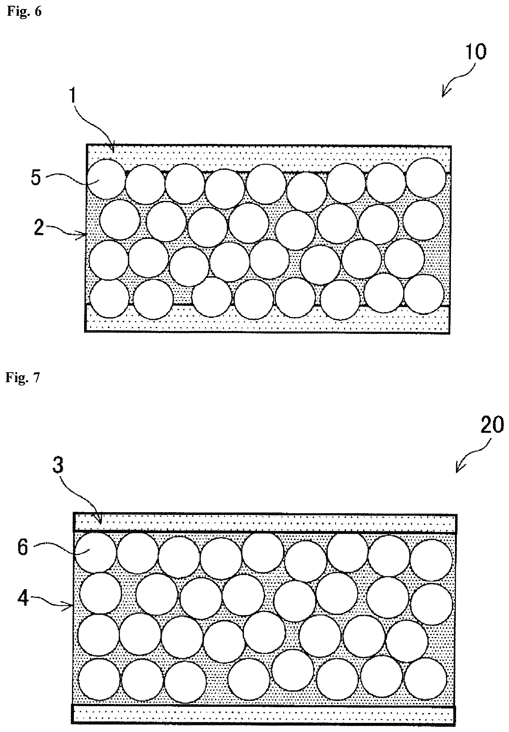

The aforementioned theory is explained with reference to the drawings. Fig. 6 is a schematic cross section that illustrates an example of the structure of cured multilayer resin sheet 10 according to the invention. Cured multilayer resin sheet 10 includes cured resin layer 2, which is a cured resin composition layer including filler 5, and adhesive layers 1 disposed on both sides of cured resin layer 2. In cured multilayer resin sheet 10, adhesive layers 1 enter concave portions of cured resin layer 2 that are formed due to the presence of filler 5, and filler 5 exists at an interface of cured resin layer 2 and adhesive layer 1.

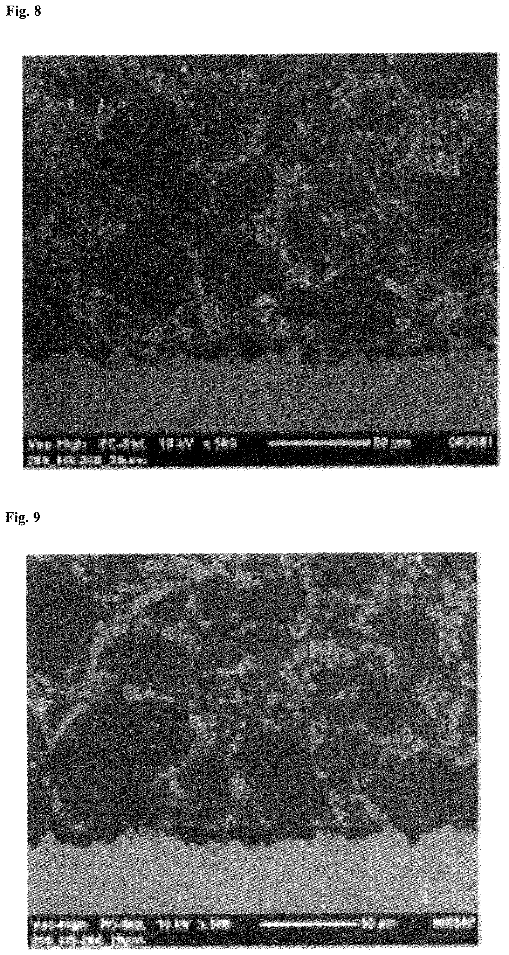

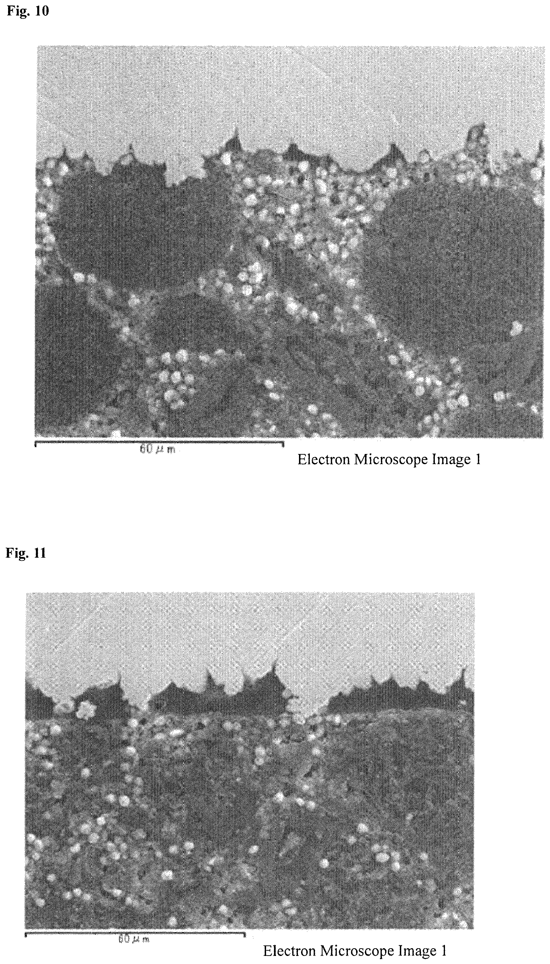

Fig. 8 and Fig. 10 show an example of a cross-section photograph of a cured multilayer resin sheet according to the embodiment. In the cured multilayer resin sheet according to the embodiment, as shown in Fig. 8 and Fig. 10, the filler exists at an interface of the cured resin layer and the adhesive layer.

On the other hand, in a case of a multilayer resin sheet having an adhesive layer formed on a resin composition layer having a smooth surface, the area of an interface is small and it is less likely to obtain an anchoring effect. Therefore, the adhesion strength between the adhesive layer and the resin composition layer tends to be insufficient. After the curing, the resin in the adhesive layer, which is low in thermal conductivity, does not enter the concave portions and the adhesive layer tends to remain the same in thickness. Therefore, the distance between the adherend and the resin composition layer remains the same, and the thermal conductivity may be insufficient.

The aforementioned theory is explained with reference to the drawings. Fig. 7 is a schematic cross section that illustrates an example of the structure of cured multilayer resin sheet 20 that is obtained by curing a multilayer resin sheet having a resin composition layer having a smooth surface. Cured multilayer resin sheet 20 includes cured resin layer 4, which is a cured resin composition layer including filler 6, and adhesive layers 3 disposed on both sides of cured resin layer 4. In cured multilayer resin sheet 20, since resin composition layer 4 does not have concave portions due to filler 5, filler 5 does not exist at an interface of cured resin layer 4 and adhesive layer 1.

Fig. 9 and Fig. 11 show an example of a cross-section photograph of a cured multilayer resin sheet that is obtained by curing a multilayer resin sheet having a resin composition layer having a smooth surface. In the cured multilayer resin sheet having a resin composition layer having a smooth surface, as shown in Fig. 9 and Fig. 11, the filler does not exist at an interface of the cured resin layer and the adhesive layer.

The cured multilayer resin sheet of the invention exhibits a high thermal conductivity because the fillers having a large volume average particle diameter contacts each other in the cured resin composition layer. In a case of a mixture of a resin and a filler, which are significantly different in thermal conductivity, it is preferred to form a path in a direction of conducting heat by positioning the fillers, which are highly thermally conductive, so as to be close to each other. For example, a thermally conductive path can be formed by allowing the fillers having a large volume average diameter to contact each other without intervention of resin, or by allowing the fillers having a small particle diameter that fill spaces among the large fillers or the fillers having a large particle diameter that fill spaces among the large fillers to contact each other without intervention of resin. As a result, a high thermal conductivity tends to be achieved.

In the cured multilayer resin sheet of the invention, the resin in the adhesive layer deforms according to the shape of the surface of the resin composition layer by performing pressing for attaching an adherend to the adhesive layer of the multilayer resin sheet prior to curing. Therefore, there are cases in which the adhesive layer itself decreases in thickness. In addition, the filler included in the resin composition layer may be pushed into the adhesive layer, and it is thought that a thermally conductive path is readily formed in a direction of thickness.

In the conventional multilayer resin sheet, in which the adhesive layer and the resin composition layer hardly interdiffuse, there are cases in which thermal conductivity may significantly decrease because the adhesive layer has a thermal conductivity that is significantly smaller than that of the resin composition layer. In that case, it is possible to improve thermal conductivity by reducing thermal resistance by decreasing the resin thickness of the adhesive layer. However, there is a physical limit in decreasing the thickness of the adhesive layer. There is also a possible way of increasing thermal conductivity by mixing a filler in the adhesive layer. However, there is a problem in that the adhesion strength may decrease if an excessive amount of the filler is mixed, and it may become difficult to maintain the balance between adhesive strength and thermal conductivity.

In the multilayer resin sheet of the invention, the resin in the adhesive layer enters concave portions of the resin composition layer by performing a pressing treatment, and the adhesive layer itself decreases in thickness. Further, since the filler that has been in the vicinity of the surface of the resin composition layer prior to the pressing treatment is pushed into the adhesive layer, it is thought that the filler exists in the vicinity of the surface of the multilayer resin sheet. As a result, it is thought that the distance between the cured resin layer obtained by curing the resin composition layer and the adherend is decreased and a structure in which boron nitride exists in a continuous manner is readily formed, whereby thermal conductivity of the inside of the cured resin layer is significantly improved.

The state in which at least a part of filler included in the resin composition layer (preferably, a filler having a large particle diameter) is embedded in the adhesive layer can be determined from, for example, the state of distribution of the filler, the state of an interface between the cured resin layer and the adhesive layer, or the structure thereof, by observing a cross section of the cured multilayer resin sheet in a direction perpendicular to the interface of the cured resin layer and the adhesive layer with a scanning electron microscope (SEM) and an electron probe X-ray microanalyser (XMA).

As necessary, the determination may be combined with chemical analysis such as IR or elemental analysis.

### <Method of Producing Cured Multilayer Resin Sheet>

The method of producing the cured multilayer resin sheet of the invention includes a process of curing the multilayer resin sheet by performing a thermal treatment.

The conditions for the thermal treatment for curing the multilayer resin sheet may be selected according to the configuration of the multilayer resin sheet. For example, the thermal treatment may be performed at a temperature of from 120°C to 250°C and a time of from 10 minutes to 300 minutes. From the viewpoint of thermal conductivity, the thermal treatment is preferably performed at a temperature at which a high-order structure is formed or a crosslinking density is increased. For example, the thermal treatment is more preferably performed in two or more steps at from 100°C to 160°C and at from 150°C to 250°C. Further, the thermal treatment is preferably performed at multiple steps of two or more at temperature ranges as described above.

The thermal treatment for curing the multilayer resin sheet is preferably performed while applying a pressure of from 0.1 MPa to 100 MPa. When the thermal treatment is performed in two steps, it is preferred to perform a first step at from 100°C to 160°C and from 0.1 MPa to 100 MPa, and a second step at from 150°C to 250°C.

The thermal treatment can be performed under atmospheric pressure (normal pressure), but may be performed under reduced pressure. In that case, the process is preferably performed at 30,000 Pa or less, more preferably at 10,000 Pa or less.

In the invention, from the viewpoint of thermal conductivity, the compression rate of the multilayer resin sheet is preferably 10% or more, more preferably 12% or more, further preferably 14% or more.

In the invention, the compression rate is defined as a value obtained by dividing the thickness of the cured multilayer resin sheet obtained by subjecting a B-stage multilayer resin sheet to a thermal treatment at a temperature of 165°C, a pressure of 10 MPa, a degree of vacuum of ≤ 1 kPa and a treatment time of 3 minutes by the thickness of the B-stage multilayer resin sheet, and subtracting the calculated result from 1.

### <Resin Sheet Laminate>

The resin sheet laminate of the invention includes a multilayer resin sheet and a metal plate or a radiation plate disposed on an adhesive layer of the multilayer resin sheet. By having this structure, the resin sheet laminate exhibits excellent thermal conductivity and insulation properties, favorable adhesion strength between the multilayer resin sheet and the metal plate or the radiation plate, and excellent thermal impact resistance.

Details of the multilayer resin sheet are as described above. Examples of the metal plate or the radiation plate include a copper plate, an aluminum plate and a ceramic plate. The thickness of the metal plate or the radiation plate is not particularly limited. A metal foil such as a copper foil or an aluminum foil may be used as the metal plate or the radiation plate.

In the invention, the metal plate or the radiation plate is disposed at least one surface of the cured multilayer resin sheet, and may be disposed on both surfaces thereof.

### <Method of Producing Resin Sheet Laminate>

The method of producing the resin sheet laminate of the invention includes a process of positioning a metal plate or a radiation plate on an adhesive layer of the multilayer resin sheet.

The method of positioning a metal plate or a radiation plate on an adhesive layer of the multilayer resin sheet is not particularly limited and may be an ordinary method, for example, a method of attaching a metal plate or a radiation plate to the adhesive layer of the multilayer resin sheet. Examples of the method for attaching include pressing and laminating.

The conditions for pressing or laminating may be selected according to the configuration of the multilayer resin sheet.

The resin sheet laminate may have a structure including a multilayer resin sheet having an adhesive layer on both sides of a resin composition layer, a metal plate or a radiation plate on one of the adhesive layer and an adherend on the other adhesion layer. The resin sheet laminate having the structure as mentioned above is capable of forming a cured resin sheet laminate that exhibits excellent thermal conductivity with respect to the adherend and the metal plate or the radiation plate by curing the resin sheet by performing a thermal treatment.

The adherend is not particularly limited. Exemplary materials for the adherend include metal, resin, ceramics, and a composite material that is a mixture of these materials.

### <Cured Resin Sheet Laminate>

The cured resin sheet laminate of the invention is a thermally-treated product of a resin sheet laminate, the resin sheet laminate including:
a resin composition layer that comprises a thermosetting resin and a filler;
an adhesive layer that is disposed on at least one surface of the resin composition layer, the adhesive layer having an arithmetic average surface roughness Ra of 1.5 µm or less at a surface that does not face the resin composition layer; and
a metal plate or a radiation plate disposed on the adhesive layer.

### <Method of Producing Cured Resin Sheet Laminate>

The method of producing the cured resin sheet laminate of the invention includes:
obtaining the resin sheet laminate by disposing the metal plate or the radiator plate on the adhesive layer of the multilayer resin sheet; and
curing the resin composition layer by applying heat to the resin sheet laminate.

The method may include other processes, as necessary. The method of disposing the metal plate or the radiation plate is as described above.

Further, in the invention, the resin sheet laminate is subjected to a thermal treatment to cure the resin composition layer after the process of obtaining the resin sheet laminate. By performing a thermal treatment, thermal conductivity is further improved. The thermal treatment may be performed at from 120°C to 250°C for from 10 minutes to 300 minutes, for example. From the viewpoint of thermal conductivity, the conditions for the thermal treatment preferably include a temperature at which a high-order structure is readily formed. In particular, the thermal treatment more preferably includes at least two heating steps performed at from 100°C to 160°C and at from 150°C to 250°C. Further preferably, the thermal treatment includes multiple heating steps of two or more performed at the temperature ranges as mentioned above.

The method of producing the cured resin sheet laminate of the invention preferably further includes a process of positioning an adherend on a surface of the resin sheet laminate that is opposite to a surface on which the metal plate or the radiation plate is disposed.

The adherend is not particularly limited. Exemplary materials for the adherend include metal, resin, ceramics, and a composite material that is a mixture of these materials.

The method of positioning an adherend on a surface of the resin sheet laminate is similar to the method of positioning a metal plate or a radiation plate as described above.

The process of positioning an adherend on a surface of the resin sheet laminate may be performed before or after the process of obtaining the resin sheet laminate, as long as it is performed before the process of curing the resin sheet laminate.

The cured resin sheet laminate, which is obtained by curing the resin composition layer of the resin sheet laminate that has a metal plate or a radiation plate on one surface and an adherend on another surface, exhibits excellent thermal conductivity with respect to the metal plate or the radiation plate and the adherend.

A preferred embodiment of the method of producing the cured resin sheet laminate of the invention may include a first process of obtaining a resin composition layer formed of a resin composition that includes a thermosetting resin monomer, a curing agent and a filler; a second process of obtaining a multilayer resin sheet by attaching an adhesive layer to at least one surface of the resin composition layer; a third process of obtaining a resin sheet laminate by attaching a metal plate or the like to the multilayer resin sheet and allowing at least a part of the filler included in the resin composition layer to be embedded in the adhesive layer; and a fourth process of curing the resin composition layer by subjecting the resin sheet laminate to a thermal treatment. The method may include other processes, as necessary.

### (First Process)

In the first process, an ordinary method of producing a multilayer resin sheet can be employed without particular limitation.

For example, a resin composition layer may be formed by preparing a resin composition by mixing a thermosetting resin monomer, a curing agent, a filler, other components as necessary and an organic solvent, applying the resin composition onto a support or the like to form a coating layer, and removing at least a part of the organic solvent from the coating layer (drying). Details of the method of forming the resin composition layer are as described above.

In the invention, the resin composition layer is obtained by removing at least a part of the organic solvent from the coating layer (drying). The coating layer from which at least a part of the organic solvent has been removed may be subjected to a further heat-and-press treatment so that the resin composition that constitutes the resin composition layer is in a semi-cured sate (B stage).

The method of subjecting the resin composition layer to a heat-and-press treatment is not particularly limited. For example, the treatment can be performed with a hot press machine or a laminator. The conditions for heating and pressing for making the resin composition that constitutes the resin composition layer into a semi-cured state may be selected according to the configuration of the resin composition, for example, at a temperature of from 60°C to 220°C, a pressure of from 0.1 MPa to 100 MPa, and a time of from 0.3 minutes to 30 minutes.

### (Second Process)

In the second process, the adhesive layer is attached on at least one surface of the resin composition layer. The second process preferably also includes a process of allowing at least a part of the filler to be embedded in the adhesive layer. Examples of the method of attaching the adhesive layer to at least one surface of the resin composition layer include a method of heating and pressing a layered structure in which a resin composition layer and an adhesive layer in the form of a film with a press machine, a laminate machine, a metal roll press machine, a vacuum press machine or the like.

The conditions for heating and pressing may be selected according to the configuration of the multilayer resin sheet, preferably a temperature of from 60°C to 220°C, a pressure of from 0.1 MPa to 100 MPa, and a time of from 0.1 minutes to 60 minutes, more preferably a temperature of from 80°C to 180°C, a pressure of from 0.2 MPa to 80 MPa, and a time of from 0.2 minutes to 20 minutes. It is further desirable to determine the conditions in consideration of the third process as described later.

The heating and pressing can be performed under atmospheric pressure (normal pressure), but preferably performed under reduced pressure. Specifically, the process is performed at 30,000 Pa or less, more preferably at 10,000 Pa or less.

### (Third Process)

In the third process, a metal plate of copper, aluminum, copper chromium alloy or nickel-plated or the like is disposed on the adhesive layer of the multilayer resin sheet and attached thereto, and at least a part of the filler (preferably, a filler having a large particle diameter) in the resin composition layer is embedded in the adhesive layer.

The process is preferably performed by a heat-and-press treatment, and specific methods include a press treatment. The press treatment is not particularly limited as long as at least a part of the filler in the resin composition layer is allowed to follow an interface with the adhesive layer and the adhesive layer is adhered to the metal plate or the like. Exemplary methods include performing a press treatment with a press machine, a laminate machine, a metal roll press machine, a vacuum press machine or the like.

The conditions for the heat-and-press treatment may be selected according to the configuration of the multilayer resin sheet. For example, the heat-and-press treatment can be performed at a temperature of from 80°C to 200°C, a pressure of from 1 MPa to 100 MPa, and a time of from 0.1 minutes to 60 minutes; more preferably at a temperature of from 100°C to 200°C, a pressure of from 1.5 MPa to 80 MPa, and a time of from 0.3 minutes to 40 minutes.

The heat-and-press treatment can be performed under atmospheric pressure (normal pressure), but preferably performed under reduced pressure. In that case, the treatment is preferably performed at 30,000 Pa or less, more preferably at 10,000 Pa or less.

By performing the heat-and-press treatment under the conditions as described above, at least a part of the filler (preferably, a filler having a large particle diameter) in the resin composition layer can be efficiently embedded in the adhesive layer.

### (Fourth Process)

In the fourth process, the resin composition layer is cured by performing a thermal treatment after the third process. By performing the thermal treatment, thermal conductivity is further improved. The thermal treatment may be performed at from 80°C to 250°C for from 0.1 minutes to 360 minutes, for example. From the viewpoint of thermal conductivity, the thermal treatment is preferably performed at a temperature at which the epoxy resin is readily oriented. In particular, the thermal treatment more preferably includes at least two heating steps performed at from 100°C to 160°C and at from 160°C to 250°C. Further preferably, the thermal treatment includes multiple heating steps of at least two performed at the temperature ranges as described above.

The cured resin sheet laminate may be formed only of the resin sheet laminate, or may be a cured product including the resin sheet laminate and an adherend attached thereto. The cured resin sheet laminate attached with an adherend exhibits excellent thermal conductivity with the metal plate or the like and the adherend, and excellent adhesion strength and insulating properties.

Further, since the filler (preferably, a filler having a large particle diameter) can deform along the shape of the surface of the adherend, the cured resin sheet laminate exhibits excellent thermal conductivity with the metal plate or the like and the adherend.

The adherend is not particularly limited. Exemplary materials for the adherend include metal, resin, ceramics and a composite material of a mixture of these materials.

The metal foil is not particularly limited and examples thereof include a gold foil, a copper foil and an aluminum foil. Typically, a copper foil is used.

### <Multilayer Resin Sheet with Metal Foil>

The multilayer resin sheet with a metal foil of the invention includes the multilayer resin sheet and a metal foil disposed on the adhesive layer of the multilayer resin sheet.

The thickness of the metal foil is not particularly limited as long as it is from 1 µm to 400 µm, and flexibility is further improved by using a metal foil of 105 µm or less.

It is also possible to use a double-layer composite foil having a structure in which an aluminum foil and a copper foil are combined, or a triple-layer composite foil having a structure in which a copper layer of from 0.5 to 15 µm and a copper layer of from 10 to 300 µm are disposed on each side of an intermediate layer of nickel, nickel-phosphorus alloy, nickel-tin alloy, nickel-iron alloy, lead, lead-tin alloy or the like.

The multilayer resin sheet having a metal foil can be produced by, for example, attaching an adhesive layer of the multilayer resin sheet to the metal foil, or by directly applying the resin composition onto the metal foil.

### <Semiconductor Device>

The semiconductor device of the invention includes a semiconductor element and the cured multilayer resin sheet.

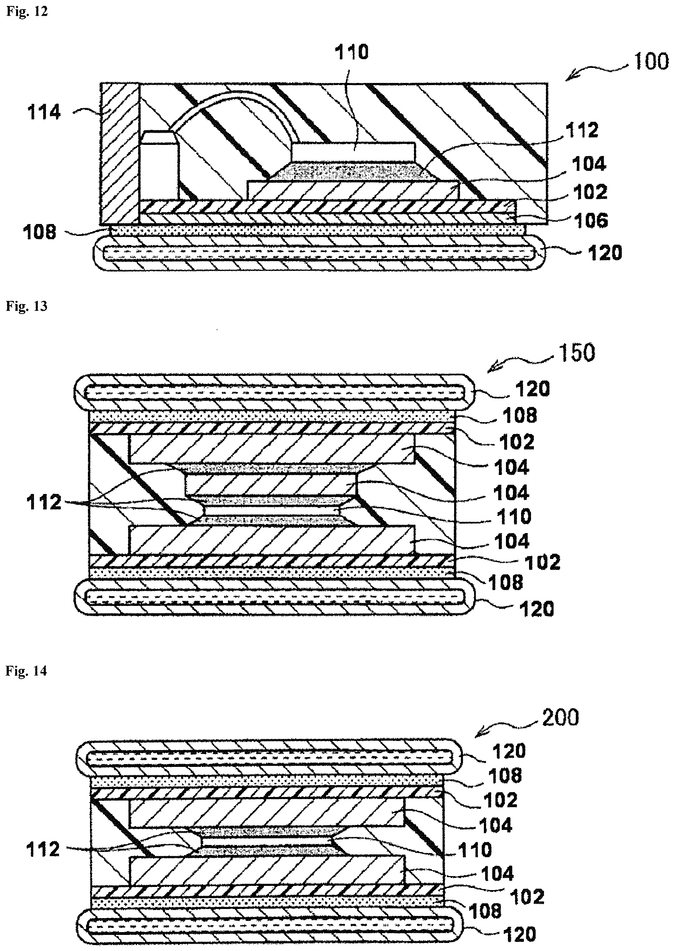

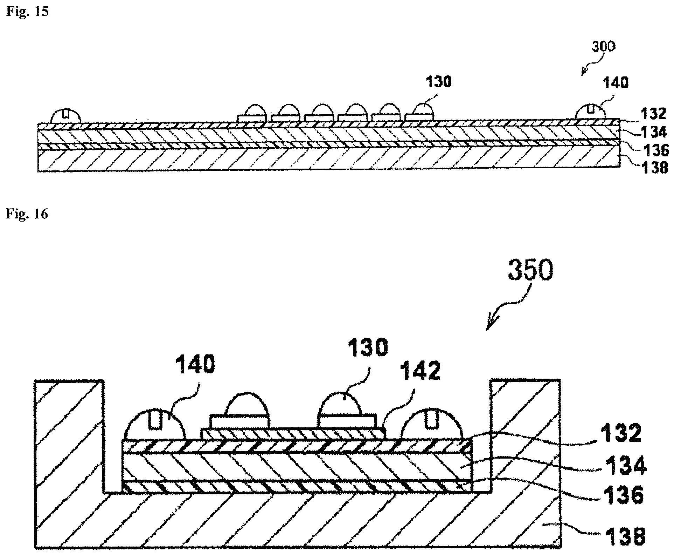

As specific examples, configurations of power semiconductor devices formed by using the semiconductor device cured multilayer resin sheet are shown in Figs. 12 to 14, and configurations of LED devices formed by using the semiconductor device cured multilayer resin sheet are shown in Figs. 15 to 18.

Fig. 12 is a schematic cross-sectional view of an exemplary structure of power semiconductor device 100 having a structure in which copper plate 104 on which power semiconductor device 110 is disposed via solder layer 112, the cured multilayer resin sheet of the invention 102, radiation base 106, and case 114 including these components are disposed on water-cooling jacket 120 via grease layer 108. Since the heat generating body including power semiconductor element 110 is in contact with a radiator via cured resin sheet 102, heat can be efficiently released. Radiation base 106 can be formed of a thermally conductive material such as copper or aluminum. Examples of the power semiconductor element include IGBT or thyristor.

Fig. 13 is a schematic cross-sectional view of an exemplary structure of power semiconductor device 150 that includes cooling members disposed on both sides of power semiconductor 110. In power semiconductor device 150, the cooling member disposed on the upper side of power semiconductor element 110 includes two copper plates 104 disposed via solder layer 112. By having this structure, occurrence of chip cracking or solder cracking can be more effectively suppressed. In Fig. 13, copper plate 104 disposed on the side remote from semiconductor element 110 is connected to water-cooling jacket 120 via cured resin sheet 102 and grease layer 108. In the cooling member disposed at the lower side of semiconductor element 110, one copper plate 104 is connected to water-cooling jacket 120 via cured resin sheet 102 and grease layer 108. In Fig. 2, cured resin sheet 102 and water-cooling jacket 120 are disposed via grease layer 108, but may be disposed so as to be in direct contact.

Fig. 14 is a schematic cross-sectional view of an exemplary structure of power semiconductor device 200 that includes cooling members disposed on both sides of power semiconductor 110. In power semiconductor device 200, the cooling members disposed on both sides of power semiconductor element 110 include one copper plate 104, respectively. In Fig. 14, cured multilayer resin sheet 102 and water-cooling jacket 120 are disposed via grease layer 108, but cured multilayer resin sheet 102 and water-cooling jacket 120 may be disposed so as to be in direct contact.

Fig. 15 is a schematic cross-sectional view of an exemplary structure of LED light bar 300 formed by using the cured multilayer resin sheet of the invention. LED light bar 300 has a structure in which housing 138, grease layer 136, aluminum substrate 134, cured resin sheet 132 and LED chips 130 are disposed in this order and fixed with screws 140. Since LED chips 130, which generate heat, are disposed on aluminum substrate 134 via cured resin sheet 132, heat can be released efficiently.

Fig. 16 is a schematic cross-sectional view of an exemplary structure of light-emitting portion 350 of an LED light bulb. Light-emitting portion 350 has a structure in which housing 138, grease layer 136, aluminum substrate 134, cured multilayer resin sheet 132, circuit layer 142 and LED chips 130 are disposed in this order and fixed with screws 140.

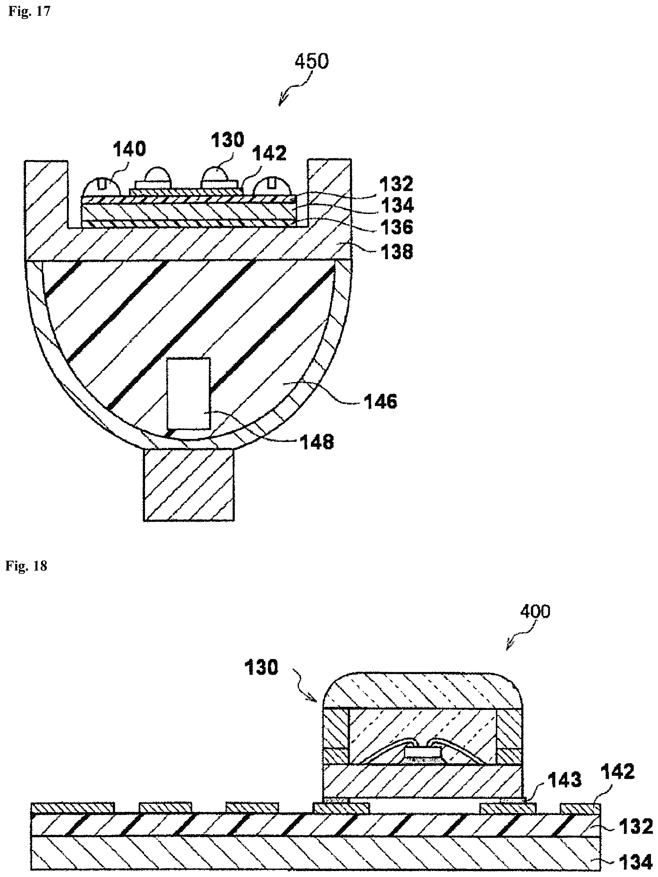

Fig. 17 is a schematic cross-sectional view of an exemplary structure of the entire body of LED light bulb 450. Housing 138 of the LED light bulb is disposed on encapsulating resin 146 that includes power source member 148.

Fig. 18 is a schematic cross-sectional view of an exemplary structure of LED substrate 400. LED substrate 400 has a structure in which aluminum substrate 134, cured multilayer resin sheet of the invention 132, circuit layer 142, solder layer 143 and LED chip 130 are disposed in this order. Since LED chip 130, which generates heat, is disposed on aluminum substrate 134 via circuit layer 142 and cured resin sheet 132, heat can be released efficiently.

### [Examples]

In the following, the invention will be described with reference to the examples, but the invention is not limited the examples. Unless otherwise specified, "part" and "%" are based on mass.

The following are materials used in the preparation of the multilayer resin sheet of the examples and abbreviation thereof.

### <Resin composition layer>

AA-18[alumina, Sumitomo Chemical Co., Ltd., volume average particle diameter: 18 µm]
AA-3 [alumina, Sumitomo Chemical Co., Ltd., volume average particle diameter: 3 µm]
AA-04[alumina, Sumitomo Chemical Co., Ltd., volume average particle diameter: 0.4 µm]
FS-3 [boron nitride, Mizushima Ferroalloy Co., Ltd., volume average particle diameter: 76 µm]
HP-40 [boron nitride, Mizushima Ferroalloy Co., Ltd., volume average particle diameter: 45 µm]

### (Curing agent)

CRN: catechol resorcinol novolac resin (solid content: 50%, cyclohexanone solution)
The catechol resorcinol novolac resin was prepared based on the method described in JP-A No. 2006-131852, Japanese Published Examined Application No. 2010-518183 and the like.

### (Epoxy resin monomer)

PNAP: (phenolnovolac + phenylaldehyde) type glycidyl ether (EPPN-502H, Nippon Kayaku Co., Ltd., epoxy equivalent: 170 g/eq)
BIS-AD: glycidyl ether of bisphenol AD mixture (ZX-1059, Nippon Steel & Sumikin Chemical Co., Ltd., epoxy equivalent: 168 g/eq)
MOPOC: 1-{(3-methyl-4-oxyranylmethoxy)phenyl}-4-(4-oxyranylmethoxyphenyl)-1-cyclohexene (epoxy equivalent: 202 g/eq)
MOPOC was prepared with reference to JP-A No. 2005-206814 and JP-A No. 2005-29778)

### (Additive)

TPP: triphenylphosphine (Wako Pure Chemical Industries, Ltd.)
PAM: 3-phenylaminopropyltrimethoxysilane (silane coupling agent: Shin-Etsu Chemical Co., Ltd., KBM-573)

### (Organic Solvent)

MEK: methylethylketone (Wako Pure Chemical Industries, Ltd., first grade)
CHN: cyclohexanone (Wako Pure Chemical Industries, Ltd., first grade)

### (Support)

PET film (Teijin DuPont Films Japan Limited, A31, thickness: 50 µm)
Copper film: Furukawa Electric Co., Ltd., thickness: 80 µm, GTS grade)

### <Adhesive Layer>

### (Filler)

AO802 [alumina, Toyo Ink Co., Ltd., volume average particle diameter: 0.7 µm] (solid content: 76%)

### (Coupling agent)

A-189: mercapto-terminated silane coupling agent, NUC Corporation
A-1160: ureido-terminated silane coupling agent, NUC Corporation (solid content: 50%)

### (Epoxy resin monomer)

YD-8170C: bisphenol F epoxy resin, Tohto Kasei Co., Ltd. (epoxy equivalent: 170 g/eq)
YDCN-703: cresol novolac epoxy resin, Tohto Kasei Co., Ltd. (solid content: 60%, epoxy equivalent: 205 g/eq)

### (Modified polyamideimide resin material)

KS-7003: modified polyamideimide varnish, Hitachi Chemical Co., Ltd. (solid content: 40%)

### (Curing agent)

g/eq)Phenol novolac LF-2882, DIC Corporation (solid content: 60%, epoxy equivalent: 108

### (Curing accelerator)

2-phenyl-4-cyanoimidazole 2PZ-CN, Shikoku Chemicals Corporation

### (Acryl modified rubber)

Acrylic rubber HTR-860P-3, Nagase ChemteX Corporation (solid content: 12%)

### (Solvent)

CHN: cyclohexanone (Wako Pure Chemical Industries, Ltd., first grade)

### (Support)

PET film (Teijin DuPont Films Japan Limited, A31)

### <Example 1>

### (Preparation of resin composition layer)

42.91 parts of an alumina mixture (AA-3 and AA-04, volume based mixed ratio 2.4:1), 46.04 parts of boron nitride (HP-40, volume based mixed ratio with respect to AA-04 6.6:1), 0.09 parts of a silane coupling agent (PAM), 7.23 parts of a CHN solution of CRN (solid content: 50%) and 46.02 parts of CHN were mixed, and it was confirmed that the mixture was uniform. Then, 11.73 parts of MOPOC as an epoxy resin monomer and 0.13 parts of TPP were further added and mixed. Then, the mixture was subjected to ball mill pulverization for 20 to 40 hours, thereby obtaining a coating liquid for forming a resin composition layer.

The obtained coating liquid for forming a resin composition layer is applied onto a surface of a PET (polyethylene terephthalate) film that had been subjected to a mold release treatment with a comma coater (Hirano Tecseed Co., Ltd.) and dried in a box-type oven at 100°C for 5 minutes. A stage sheet 1, having a structure in which an A-stage resin composition layer was formed on the PET film, was thus obtained.

Two of A-stage sheets prepared above, in which the resin composition layer was formed on the PET film, were layered such that the resin composition layers faced each other and attached by subjecting the same to a heat-and-press treatment with a hot press machine (hot plate: 150°C, pressure: 15 MPa, treatment time: 1 minute). Then, the PET films were peeled off and a B-stage resin composition layer having a thickness of 184 µm was prepared.

Subsequently, the surface roughness of the B-stage resin composition layer was measured with a surface roughness measurement device (Kosaka Laboratory Ltd.) at a measurement condition of 1 mm/s.

### (Preparation of adhesive layer film 1: epoxy adhesive layer)

24.2 parts of YD-8170C and 13.5 parts of YDCN-703 as an epoxy resin, 30.67 parts of LF-2882 as a curing agent, 0.083 parts of 2PZ-CN as a curing accelerator, 196.53 parts of HTR-860P-3 as an acryl-modified rubber, 0.21 parts of A-189 and 0.83 parts of A-1160 as a coupling agent and 231.58 parts of AO-802 as a filler were mixed in a mixer for 1 hour, thereby obtaining a coating liquid for forming an adhesive layer. Subsequently, the coating liquid was applied onto a PET film A31 that had been subjected to a mold releasing treatment, and dried for approximately 6 minutes in a conveyer-type drying oven set at 100°C, whereby adhesive layer film 1 having a structure in which an adhesive layer was formed on the PET film was obtained. The thickness of the adhesive layer was adjusted to be 10 µm.

### (Preparation of adhesive layer film 2: polyamideimide resin adhesive layer, no filler)

A varnish of modified polyamideimide resin (Hitachi Chemical Co., Ltd., product name: KS7003, solid content: 40% by mass) was applied onto a PET film that had been subjected to a mold release treatment with a comma coater (Hirano Tecseed Co., Ltd.) Drying was performed for approximately 8 minutes in a conveyer-type drying oven set at from 130 to 140°C. Adhesive layer film 2 having a structure in which an adhesive layer was formed on the PET film was thus obtained. The thickness of the adhesive layer was 6 µm.

### (Preparation of adhesive layer film 3: polyamideimide resin adhesive layer, with filler)

A varnish was prepared by adding 12.9 parts of AO802 to 10 parts of a varnish of modified polyamideimide resin (Hitachi Chemical Co., Ltd., product name: KS7003, solid content: 40% by mass). The obtained varnish was applied onto a PET film that had been subjected to a mold release treatment with a comma coater (Hirano Tecseed Co., Ltd.) Drying was performed for approximately 8 minutes in a conveyer-type drying oven set at from 130 to 140°C. Adhesive layer film 3 having a structure in which an adhesive layer was formed on the PET film was thus obtained. The thickness of the adhesive layer was 8 µm.

### (Preparation of multilayer resin sheet)

On both sides of the B-stage resin composition layer, adhesive layer film 2 (a PET film on which an adhesive layer of polyamideimide resin was formed) was placed such that the adhesive layer was in contact with the B-stage resin composition layer. With a laminator (Meiki Co., Ltd., MVLP-600/700), the adhesive layers having insulating properties were attached to both sides of the resin composition layer, thereby obtaining a multilayer resin sheet (hereinafter, also referred to as a B-stage sheet).

### (Preparation of cured resin sheet laminate)

The PET films were peeled off from the multilayer resin sheet obtained above, and a copper foil having a thickness of 80 µm was placed on both sides of the resin composition layer and a press treatment was performed (press conditions: hot plate temperature: 165°C, degree of vacuum: ≤ 1kPa, pressure: 10 MPa, treatment time: 3 minutes). Then, the resultant was subjected to a thermal treatment in a box-type oven at 140°C for 2 hours, at 165°C for 2 hours and at 190°C for 2 hours. Cured resin sheet laminate 1 in a C-stage state, including the multilayer resin sheet and copper foils disposed on both sides thereof, was thus obtained.

### <Example 2>

Cured resin sheet laminate 2, including a multilayer resin sheet and copper foils disposed on both sides of the multilayer resin sheet, was prepared by the same process as Example 1, except that adhesive layer film 1 (PET film on which an adhesive layer of epoxy resin was formed) was used instead of adhesive layer film 2.

### <Example 3>

Cured resin sheet laminate 3, including a multilayer resin sheet and copper foils disposed on both sides of the multilayer resin sheet, was prepared by the same process as Example 1, except that adhesive layer film 3 (a PET film on which an adhesive layer of polyimideamide resin with filler was formed) was used instead of adhesive layer film 2.

### <Example 4>

Cured resin sheet laminate 4, including a multilayer resin sheet and copper foils disposed on both sides of the multilayer resin sheet, was prepared by the same process as Example 1, except that a mixture of FS-3 and HP-40 (volume based mixture ratio 1:1) was used instead of HP-40.

### <Example 5>

Cured resin sheet laminate 5, including a multilayer resin sheet and copper foils disposed on both sides of the multilayer resin sheet, was prepared by the same process as Example 4, except that adhesive layer film 1 (PET film on which an adhesive layer of epoxy resin was formed) was used instead of adhesive layer film 2.

### <Example 6>

Cured resin sheet laminate 6, including a multilayer resin sheet and copper foils disposed on both sides of the multilayer resin sheet, was prepared by the same process as Example 4, except that adhesive layer film 3 (PET film on which an adhesive layer of polyamideimide resin (including filler) was formed) was used instead of adhesive layer film 2.

### <Example 7>

Cured resin sheet laminate 7, including a multilayer resin sheet and copper foils disposed on both sides of the multilayer resin sheet, was prepared by the same process as Example 1, except that a 1:1 mixture of PNAP and BIS-AD was used instead of MOPOC.

Specifically, 42.91 parts of alumina mixture (AA-3 and AA-04, volume based mixed ratio 2.4:1), 46.04 parts of boron nitride (HP-40, volume based mixed ratio with respect to AA-04 6.6:1), 0.09 parts of a silane coupling agent (PAM), 8.70 parts of a CHN solution of CRN (solid content: 50%) and 46.02 parts of CHN were mixed, and it was confirmed that the mixture was uniform. Subsequently, 5.90 parts of PNAP and 5.90 parts of BIS-AD as epoxy resin monomers and 0.13 parts of TPP were added and mixed. Then, the mixture was subjected to ball mill pulverization for 20 to 40 hours, thereby obtaining a coating liquid for forming a resin composition layer.

The coating liquid for forming a resin composition layer obtained above was applied on a surface of a PET (polyethylene terephthalate) film that had been subjected to a mold release treatment with a comma coater (Hirano Tecseed Co., Ltd.) Drying was performed for 5 minutes in a box-type oven set at 100°C, and A-stage sheet 3 having a structure in which an A-stage resin composition layer was formed on a PET film was obtained.

The subsequent processes were performed in the same manner as Example 1.

### <Example 8>

Cured resin sheet laminate 8, including a multilayer resin sheet and copper foils disposed on both sides of the multilayer resin sheet, was prepared by the same process as Example 7, except that adhesive layer film 1 (PET film on which an adhesive layer of epoxy resin was formed) was used instead of adhesive layer film 2.

### <Example 9>

Cured resin sheet laminate 9, including a multilayer resin sheet and copper foils disposed on both sides of the multilayer resin sheet, was prepared by the same process as Example 7, except that adhesive layer film 3 (a PET film on which an adhesive layer of polyamideimide resin (with filler) was formed) was used instead of adhesive layer film 2.

### <Reference Example 10>

Cured resin sheet laminate 10, including a multilayer resin sheet and copper foils disposed on both sides of the multilayer resin sheet, was prepared by the same process as Example 1, except that 46.04 parts of FS-3 were used instead of HP-40.

### < Reference Example 11>

Cured resin sheet laminate 11, including a multilayer resin sheet and copper foils disposed on both sides of the multilayer resin sheet, was prepared by the same process as Reference Example 10, except that adhesive layer film 1 (a PET film on which an adhesive layer of epoxy resin was formed) was used instead of adhesive layer film 2.

### < Reference Example 12>

Cured resin sheet laminate 12, including a multilayer resin sheet and copper foils disposed on both sides of the multilayer resin sheet, was prepared by the same process as Reference Example 10, except that adhesive layer film 3 (a PET film on which an adhesive layer of polyamideimide (including filler) was formed) was used instead of adhesive layer film 2.

### <Example 13>

42.91 parts of an alumina mixture (AA-3 and AA-04, volume based mixed ratio 2.4:1), 46.02 parts of boron nitride (HP-40, volume based mixed ratio with respect to AA-04 6.6:1), 0.09 parts of a silane coupling agent (PAM), 10.93 parts of a CHN solution of CRN (solid content: 50%) and 31.33 parts of CHN were mixed, and it was confirmed that the mixture was uniform. Subsequently, 7.41 parts of PNAP and 7.41 parts of BIS-AD as epoxy resin monomers and 0.16 parts of TPP were added and mixed. Then, the mixture was subjected to ball mill pulverization for 20 to 40 hours, thereby obtaining a coating liquid for forming a resin composition layer.

Thereafter, cured resin sheet laminate 13, including a multilayer resin sheet and copper foils disposed on both sides of the multilayer resin sheet, was prepared by the same process as Example 1, except that adhesive layer film 3 (a PET film on which an adhesive layer of polyamideimide (with filler) was formed) was used.

### <Example 14>

42.91 parts of alumina mixture (AA-3 and AA-04, volume based mixed ratio 2.4:1), 46.02 parts of boron nitride (HP-40, volume based mixed ratio with respect to AA-04 6.6:1), 0.09 parts of a silane coupling agent (PAM), 13.50 parts of a CHN solution of CRN (solid content: 50%) as a curing agent for an epoxy resin and 38.8 parts of CHN were mixed, and it was confirmed that the mixture was uniform. Subsequently, 9.17 parts of PNAP and 9.17 parts of BIS-AD as epoxy resin monomers and 0.20 parts of TPP were added and mixed. Then, the mixture was subjected to ball mill pulverization for 20 to 40 hours, thereby obtaining a coating liquid for forming a resin composition layer.

Thereafter, cured resin sheet laminate 14, including a multilayer resin sheet and copper foils disposed on both sides of the multilayer resin sheet, was prepared by the same process as Example 1, except that adhesive layer film 3 (a PET film on which an adhesive layer of polyamideimide (with filler) was formed) was used.

### <Example 15>

75.55 parts of alumina mixture (AA-18, AA-3 and AA-04, volume based mixed ratio 2.6:2.4:1), 27.84 parts of boron nitride (HP-40, volume based mixed ratio with respect to AA-04 6.6:1), 0.10 parts of a silane coupling agent (PAM), 8.68 parts of a CHN solution of CRN (solid content: 50%) as a curing agent for an epoxy resin and 24.89 parts of CHN were mixed, and it was confirmed that the mixture was uniform. Subsequently, 5.88 parts of PNAP and 5.88 parts of BIS-AD as epoxy resin monomers and 0.13 parts of TPP were added and mixed. Then, the mixture was subjected to ball mill pulverization for 20 to 40 hours, thereby obtaining a coating liquid for forming a resin composition layer.

Thereafter, cured resin sheet laminate 15, including a multilayer resin sheet and copper foils disposed on both sides of the multilayer resin sheet, was prepared by the same process as Example 1, except that adhesive layer film 3 (a PET film on which an adhesive layer of polyamideimide (with filler) was formed) was used.

### <Example 16>

100.94 parts of alumina mixture (AA-18, AA-3 and AA-04, volume based mixed ratio 2.6:2.4:1), 13.95 parts of boron nitride (HP-40, volume based mixed ratio with respect to AA-04 6.6:1), 0.11 parts of a silane coupling agent (PAM), 8.70 parts of a CHN solution of CRN (solid content: 50%) as a curing agent for an epoxy resin and 24.94 parts of CHN were mixed, and it was confirmed that the mixture was uniform. Subsequently, 5.90 parts of PNAP and 5.90 parts of BIS-AD as epoxy resin monomers and 0.13 parts of TPP were added and mixed. Then, the mixture was subjected to ball mill pulverization for 20 to 40 hours, thereby obtaining a coating liquid for forming a resin composition layer.

Thereafter, cured resin sheet laminate 16, including a multilayer resin sheet and copper foils disposed on both sides of the multilayer resin sheet, was prepared by the same process as Example 1, except that adhesive layer film 3 (a PET film on which an adhesive layer of polyamideimide (with filler) was formed) was used.

### <Example 17>

### (Preparation of multilayer resin sheet)

A-stage sheet 1 obtained in Example 1 and adhesive layer film 1 (having epoxy resin adhesive layer) were layered such that the resin composition layer and the adhesive layer were in contact with each other, and bonded by performing a heat-and-press treatment with a hot press machine (hot plate: 150°C, pressure: 10 MPa, treatment time: 1 minute). A multilayer resin sheet having a structure in which an adhesive layer was disposed on one surface of a B-stage resin composition layer having a thickness of 112 µm was thus obtained.

### (Preparation of resin sheet laminate)

The PET film was peeled off from the multilayer resin sheet obtained above, and a copper foil having a thickness of 80 µm (Furukawa Electric Co., Ltd., thickness: 80 µm, GTS grade) was placed on both sides of the multilayer resin sheet, and a press treatment was performed (press conditions: hot plate temperature 165°C, degree of vacuum ≤ 1 kPa, pressure: 10 MPa, treatment time: 3 minutes). Then, the multilayer resin sheet was subjected to a thermal treatment in a box-type oven at 140°C for 2 hours, at 165°C for 2 hours and at 190°C for 2 hours, thereby obtaining cured resin sheet laminate 10 having copper foils disposed on both sides.

### <Example 18>

Cured resin sheet laminate 11, including a multilayer resin sheet and copper foils disposed on both sides of the multilayer resin sheet, was prepared by the same process as Example 10, except that A-stage sheet 1 prepared in Example 1 was used and that adhesive layer film 3 was used instead of adhesive layer film 1.

### <Example 19>

Cured resin sheet laminate 12, including a multilayer resin sheet and copper foils disposed on both sides of the multilayer resin sheet, was prepared by the same process as Example 10, except that A-stage sheet 3 prepared in Example 7 (PNAP sheet) was used instead of A-stage sheet 1 prepared in Example 1.

### <Example 20>

Cured resin sheet laminate 11, including a multilayer resin sheet and copper foils disposed on both sides of the multilayer resin sheet, was prepared by the same process as Example 12, except that A-stage sheet 3 prepared in Example 7 was used and that adhesive layer film 3 was used instead of adhesive layer film 2.

### <Comparative Example 1>

### (Preparation of resin composition layer)

126.2 parts of alumina mixture (AA-18, AA-3 and AA-04, volume based mixed ratio 6.6:2.4:1), 0.13 parts of a silane coupling agent (PAM; KBM-573), 11.96 parts of a CHN solution of CRN (solid content: 50%) as a curing agent for an epoxy resin, 44.77 parts of MEK and 9.29 parts of CHN were mixed, and it was confirmed that the mixture was uniform. Subsequently, 19.39 parts of MOPOC as an epoxy resin monomer and 0.20 parts of TPP were added and mixed. Then, the mixture was subjected to ball mill pulverization for 20 to 40 hours, thereby obtaining a coating liquid for forming a resin composition layer.

The coating liquid for forming a resin composition layer obtained above was applied onto a surface of a PET (polyethylene terephthalate) film that had been subjected to a mold release treatment with a comma coater (Hirano Tecseed Co., Ltd.) Drying was performed for 15 minutes in a box-type oven set at 100°C, and A-stage sheet 4 having a structure in which an A-stage resin composition layer was formed on a PET film was obtained.

Two A-stage sheets 4 obtained above were layered such that the resin composition layers faced each other, and attached with a laminator at a temperature of 130°C, a pressure of 1 MPa, a degree of vacuum of ≤ 1 kPa and a time of 15 seconds. Then, the PET films were peeled off and a B-stage resin composition layer having a thickness of 195 µm was obtained.

Subsequently, the arithmetic average surface roughness Ra of the B-stage resin composition layer was measured with a surface roughness measurement device (Kosaka Laboratory Ltd.) at a measurement condition of 1 mm/s.

### (Preparation of multilayer resin sheet)

On both sides of the B-stage resin composition layer obtained above, the PET film on which an adhesive layer of polyamideimide resin was formed (adhesive layer film 2) obtained above was placed such that the adhesive layer was in contact with the B-stage resin composition layer, respectively, and bonded with a laminator at a temperature of 110°C, a pressure of 0.7 MPa, a degree of vacuum of ≤ 1 kPa, and a time of 15 seconds. A multilayer resin sheet was thus obtained.

### (Preparation of resin sheet laminate)

The PET films were peeled off from both sides of the multilayer resin sheet obtained above, and a copper foil having a thickness of 80 µm (Furukawa Electric Co., Ltd., thickness: 80 µm, GTS grade) was placed thereon and a pressing treatment was performed (hot plate temperature: 165°C, degree of vacuum: ≤ 1 kPa, pressure: 10 MPa, treatment time: 3 minutes). Thereafter, a thermal treatment was performed in a box-type oven at 140°C for 2 hours, at 165°C for 2 hours and at 190°C for 2 hours. Cured resin sheet laminate 9 with copper foils disposed on both sides thereof was thus obtained.

### <Comparative Example 2>

Cured resin sheet laminate 10, including a multilayer resin sheet and copper foils disposed on both sides of the multilayer resin sheet, was prepared by the same process as Comparative Example 1, except that adhesive layer film 1 (PET film on which an adhesive layer of epoxy resin was formed) was used instead of adhesive layer film 2.

### <Comparative Example 3>

Cured resin sheet laminate 11, including a multilayer resin sheet and copper foils disposed on both sides of the multilayer resin sheet, was prepared by the same process as Example 7, except that 46.04 parts of FS-3 (volume based mixed ratio with respect to AA-04: 6.6) were used instead of HP-40 as the boron nitride filler.

### <Comparative Example 4>

Cured resin sheet laminate 12, including a multilayer resin sheet and copper foils disposed on both sides of the multilayer resin sheet, was prepared by the same process as Comparative Example 3, except that adhesive layer film 1 (PET film on which an adhesive layer of epoxy resin was formed) was used instead of adhesive layer film 2.

### <Comparative Example 5>

A-stage sheet 4 obtained in Comparative Example 1 was subjected to a heat-and-press treatment with a hot press machine (hot plate: 180°C, pressure: 10 MPa, treatment time: 10 minutes), and a resin sheet that had been flattened was obtained.

Subsequently, the flattened resin sheet was attached to adhesive layer film 1 (a PET film on which an adhesive layer of epoxy resin was formed) with a vacuum laminator at a temperature of 120°C, a pressure of 0.7 MPa, a degree of vacuum of ≤ 1 kPa and a time of 15 seconds, thereby obtaining a multilayer resin sheet having a thickness of 113 µm. Then, a copper foil was attached to both sides of the multilayer resin sheet in the same manner as Comparative Example 1. Thereafter, a thermal treatment was performed in a box-type oven at 140°C for 2 hours, at 165°C for 2 hours and at 190°C for 2 hours. Cured resin sheet laminate 13 with copper foils disposed on both sides thereof was thus obtained.

### <Comparative Example 6>

Cured resin sheet laminate 14 with copper foils disposed on both sides thereof was obtained by the same process as Comparative Example 5, except that a resin sheet obtained by performing a flattening treatment to an A-stage sheet obtained in Comparative Example 3 was used instead of A-stage sheet 4.

### <Evaluation>

The copper foils were removed by etching from the cured resin sheet laminate (C-stage sheet) and the multilayer resin sheet (B-stage sheet) obtained above, and the following evaluation was performed. The results are shown in Tables 1 to 3.

### (Thermal conductivity of C-stage sheet)

A cured multilayer resin sheet (C-stage sheet) was obtained by removing copper from the cured resin sheet laminate obtained above by performing etching with a sodium persulfate solution. The obtained multilayer resin sheet was cut into a size of 10 mm square and blackened with graphite spray, and thermal diffusivity was measured with NANOFLASH LFA447 (Netzsch).

The measurement was performed at a temperature of 25±1°C, a voltage of 270V, an amplitude of 5,000 and a pulse width of 0.06 ms.

### (Dielectric strength voltage of B-stage sheet)

The B-stage sheet was sandwiched by an aluminum electrode of 20 mm in diameter and an aluminum plate of 50 mm square, and the dielectric strength voltage under alternating current was measured with YST-243-100 RHO (Yamayo Shiken-ki). The measurement was performed at a voltage increase rate of 1 kV/second and a measurement temperature of 23°C ± 2°C, in the atmosphere.

### (Dielectric strength voltage of C-stage sheet)

A cured multilayer resin sheet (C-stage sheet) was obtained by removing copper from the cured resin sheet by performing etching with a sodium persulfate solution. The dielectric strength voltage under alternating current was measured with YST-243-100 RHO (Yamayo Shiken-ki). The measurement was performed at a voltage increase rate of 1 kV/second and a measurement temperature of 23°C ± 2°C, in the atmosphere.

### (Shear bond strength of B-stage sheet)

The PET films were peeled off from the both sides of the B-stage sheet, and metal plates were attached thereto. The tensile shear bond strength was measured in accordance with JIS K 6850. Specifically, the B-stage sheet having a size of 12.5 mm × 25 mm × 0.2 mm was sandwiched by two copper plates having a size of 100 mm × 25 mm × 3 mm, and bonded and cured. The measurement was performed by pulling the copper plates at a test rate of 1 mm/minute and a temperature of 23°C with AGC-100 (Shimadzu Corporation). The bonding was performed with a vacuum hot press machine (hot plate temperature: 165°C, degree of vacuum: ≤ 1 kPa, pressure: 4 MPa, treatment time: 3 minutes).

### (Shear bond strength of C-stage sheet)

The PET films were peeled off from the both sides of the B-stage sheet, and metal plates were attached thereto. The tensile shear bond strength was measured in accordance with JIS K 6850. Specifically, the B-stage sheet having a size of 12.5 mm × 25 mm × 0.2 mm was sandwiched by two copper plates having a size of 100 mm × 25 mm × 3 mm, and bonded and cured. The measurement was performed by pulling the copper plates at a test rate of 1 mm/minute and temperatures of 23°C and 175°C with AGC-100 (Shimadzu Corporation).

The bonding and the curing were performed by performing vacuum hot pressing (hot plate temperature: 165°C, degree of vacuum: ≤ 1 kPa, pressure: 4 MPa, treatment time: 3 minutes) and performing step curing in a box-type oven at 140°C for 2 hours, at 165°C for 2 hours and at 190°C for 2 hours.

### (Measurement of surface roughness of B-stage sheet)

The surface roughness of the adhesive layer of the B-stage multilayer resin sheet was measured with a surface roughness measurement instrument (Kosaka Laboratory Ltd.) at 1 mm/s. The surface roughness was evaluated by an arithmetic average roughness. The measurement was performed on the adhesive surface after removing the support therefrom.

### (Average thickness of C-stage sheet)

A cured multilayer resin sheet (C-stage sheet) was obtained by removing copper from the cured resin sheet laminate by performing etching with a sodium persulfate solution. The obtained cured multilayer resin sheet was cut into a size of 100 mm square, and the thickness was measured at 9 points with a micrometer (IP65, Mitutoyo Corporation) and the arithmetic average value thereof was defined as the thickness of the entire sheet.

### (Compression rate)

The total of the thickness of the resin composition layer as a B-stage sheet and the thickness of the adhesive layer prior to being attached to the resin composition layer was divided by the thickness of the cured multilayer resin sheet, and the resulting value was subtracted from 1 and expressed by percentage as the compression rate.

### (Determination of sate of embedment of filler)

The state of embedment of the filler in the adhesive layer was evaluated by the following process. Two samples of a multilayer resin sheet, before and after the pressing, were prepared and a cross section with respect to an interface of the resin composition layer and the adhesive layer of the samples were observed with a scanning electron microscope (SEM, INCA ENERGY 350, Oxford Instruments PLC.) and an accompanying electron X-ray microanalyzer (XMA, accelerating voltage: 20 kV, evaporant: Pt-Pd). The existence of the filler in the adhesive layer was determined from the state of distribution of the filler, interface of the resin composition layer and the adhesive layer and the structure thereof.

**Table 1**

| | | | Example 1 | Example 2 | Example 3 | Example 4 | Example 5 | Example 6 | Example 7 | Example 8 | Example 9 |
|---|---|---|---|---|---|---|---|---|---|---|---|
| Resin composition layer | Filler (parts) | AA-18 (18 µm) | 0 | 0 | 0 | 0 | 0 | 0 | 0 | 0 | 0 |
| | | AA-3 (3 µm) | 30.29 | 30.29 | 30.29 | 30.29 | 30.29 | 30.29 | 30.29 | 30.29 | 30.29 |
| | | AA-04 (0.4 µm) | 12.62 | 12.62 | 12.62 | 12.62 | 12.62 | 12.62 | 12.62 | 12.62 | 12.62 |
| | | HP-40 (45 µm) | 46.04 | 46.04 | 46.04 | 23.02 | 23.02 | 23.02 | 46.04 | 46.04 | 46.04 |
| | | FS-3 (76 µm) | 0 | 0 | 0 | 23.02 | 23.02 | 23.02 | 0 | 0 | 0 |
| | Epoxy resin (parts) | MOPOC | 11.726 | 11.726 | 11.726 | 11.726 | 11.726 | 11.726 | 0 | 0 | 0 |
| | | PNAP | 0 | 0 | 0 | 0 | 0 | 0 | 5.90 | 5.90 | 5.90 |
| | | Bis-AD | 0 | 0 | 0 | 0 | 0 | 0 | 5.90 | 5.90 | 5.90 |
| | Curing agent (parts) | CRN | 7.23 | 7.23 | 7.23 | 7.23 | 7.23 | 7.23 | 8.70 | 8.70 | 8.70 |
| | Coupling agent (parts) | PAM | 0.09 | 0.09 | 0.09 | 0.09 | 0.09 | 0.09 | 0.09 | 0.09 | 0.09 |
| | Catalyst (parts) | TPP | 0.13 | 0.13 | 0.13 | 0.13 | 0.13 | 0.13 | 0.13 | 0.13 | 0.13 |
| | Solvent (parts) | CHN | 46.02 | 46.02 | 46.02 | 46.02 | 46.02 | 46.02 | 46.02 | 46.02 | 46.02 |
| | Boron nitride filler content (vol%) | | 47 | 47 | 47 | 47 | 47 | 47 | 47 | 47 | 47 |
| | Filler total content (vol%) | | 70 | 70 | 70 | 70 | 70 | 70 | 70 | 70 | 70 |
| | Thickness at stage B (µm) | | 218 | 221 | 220 | 219 | 222 | 220 | 219 | 220 | 218 |
| Adhesive layer | Resin type | | Modified PAI | Epoxy | Modified PAI with filler | Modified PAI | Epoxy | Modified PAI with filler | Modified PAI | Epoxy | Modified PAI with filler |
| | Thickness (µm) | | 6 | 10 | 8 | 6 | 10 | 8 | 6 | 10 | 8 |
| | Adhesive layer | | Both sides | Both sides | Both sides | Both sides | Both sides | Both sides | Both sides | Both sides | Both sides |
| Filler embedment | | | Yes | Yes | Yes | Yes | Yes | Yes | Yes | Yes | Yes |
| Properties | Average thickness of total multilayer resin sheet (µm) | | 230 | 241 | 236 | 231 | 242 | 236 | 231 | 240 | 234 |
| | Average thickness of total cured multilayer resin sheet (µm) | | 194 | 202 | 198 | 192 | 200 | 198 | 202 | 210 | 206 |
| | Compression rate (%) | | 15.7 | 16.2 | 16.1 | 16.9 | 17.4 | 16.1 | 12.6 | 12.5 | 12.0 |
| | Arithmetic average surface roughness (µm) | Resin composition layer | 2.9 | 2.9 | 2.9 | 3.6 | 3.6 | 3.6 | 2.5 | 2.5 | 2.5 |
| | | Adhesive layer | 0.6 | 0.9 | 1.2 | 0.8 | 1.2 | 1.2 | 0.7 | 0.6 | 1.3 |
| | Thermal conductivity (W/mK) | | 10 | 11 | 12 | 11 | 11 | 12 | 10 | 10 | 11 |
| | Shear strength (MPa) | Stage B | 6 | 6 | 5 | 4 | 4 | 5 | 6 | 6 | 4 |
| | | Stage C | 8 | 8 | 10 | 6 | 6 | 10 | 8 | 8 | 11 |
| | Dielectric strength voltage (kV) | Stage B | 5 | 5 | 4 | 4 | 4 | 4 | 5 | 5 | 4 |
| | | Stage C | 9 | 9 | 12 | 7 | 7 | 12 | 9 | 9 | 11 |

**Table 2**

| | | | Example 10* | Example 11* | Example 12* | Example 13 | Example 14 | Example 15 | Example 16 | Example 17 | Example 18 | Example 19 | Example 20 |
|---|---|---|---|---|---|---|---|---|---|---|---|---|---|
| Resin composition layer | Filler (parts) | AA-18 (18 µm) | 0 | 0 | 0 | 0 | 0 | 32.71 | 58.04 | 0 | 0 | 0 | 0 |
| | | AA-3 (3 µm) | 30.29 | 30.29 | 30.29 | 30.28 | 30.28 | 30.22 | 30.28 | 30.29 | 30.29 | 30.29 | 30.29 |
| | | AA-04 (0.4 µm) | 12.62 | 12.62 | 12.62 | 12.62 | 12.62 | 12.62 | 12.62 | 12.62 | 12.62 | 12.62 | 12.62 |
| | | HP-40 (45 µm) | 0 | 0 | 0 | 46.02 | 46.02 | 27.84 | 13.95 | 46.04 | 46.04 | 46.04 | 46.04 |
| | | FS-3 (76 µm) | 46.04 | 46.04 | 46.04 | 0 | 0 | 0 | 0 | 0 | 0 | 0 | 0 |
| | Epoxy resin (parts) | MOPOC | 11.73 | 11.73 | 11.73 | 0 | 0 | 0 | 0 | 11.73 | 11.73 | 0 | 0 |
| | | PNAP | 0 | 0 | 0 | 7.41 | 9.17 | 5.88 | 5.90 | 0 | 0 | 5.90 | 5.90 |
| | | Bis-AD | 0 | 0 | 0 | 7.41 | 9.17 | 5.88 | 5.90 | 0 | 0 | 5.90 | 5.90 |
| | Curing agent (parts) | CRN | 7.23 | 7.23 | 7.23 | 10.93 | 13.50 | 8.68 | 8.70 | 7.23 | 7.23 | 8.70 | 8.70 |
| | Coupling agent (part) | PAM | 0.09 | 0.09 | 0.09 | 0.09 | 0.09 | 0.10 | 0.11 | 0.09 | 0.09 | 0.09 | 0.09 |
| | Catalyst (parts) | TPP | 0.13 | 0.13 | 0.13 | 0.16 | 0.20 | 0.13 | 0.13 | 0.13 | 0.13 | 0.13 | 0.13 |
| | Solvent (parts) | CHN | 46.02 | 46.02 | 46.02 | 31.33 | 38.8 | 24.89 | 24.94 | 46.02 | 46.02 | 46.02 | 46.02 |
| | Boron nitride filler content (vol%) | | 47 | 47 | 47 | 43 | 40 | 28 | 14 | 47 | 47 | 47 | 47 |
| | Filler total content (vol%) | | 70 | 70 | 70 | 65 | 60 | 70 | 70 | 70 | 70 | 70 | 70 |
| | Thickness at Stage B (µm) | | 232 | 234 | 235 | 232 | 240 | 228 | 220 | 112 | 108 | 111 | 109 |
| Adhesive layer | Resin type | | Modified PAI | Epoxy | Modified PAI with filler | Modified PAI with filler | Modified PAI with filler | Modified PAI with filler | Modified PAI with filler | Epoxy | Modified PAI with filler | Epoxy | Modified PAI with filler |
| | Thickness (µm) | | 6 | 10 | 8 | 8 | 8 | 8 | 8 | 10 | 8 | 10 | 8 |
| | Adhesive layer | | Both sides | Both sides | Both sides | Both sides | Both sides | Both sides | Both sides | One side | One side | One side | One side |
| Filler embedment | | | Yes | Yes | Yes | Yes | Yes | Yes | Yes | Yes | Yes | Yes | Yes |
| Properties | Average thickness of total multilayer resin sheet (µm) | | 244 | 254 | 251 | 248 | 256 | 244 | 236 | 122 | 116 | 121 | 117 |
| | Average thickness of total cured multilayer resin sheet (µm) | | 204 | 208 | 204 | 201 | 195 | 208 | 210 | 109 | 102 | 105 | 104 |
| | Compression rate (%) | | 16.4 | 18.1 | 18.7 | 19.0 | 23.8 | 14.8 | 11.0 | 10.7 | 12.1 | 13.2 | 11.1 |
| | Arithmetic average surface roughness (µm) | Resin composition layer | 5.1 | 5.1 | 5.1 | 2.8 | 2.4 | 2.5 | 1.8 | 2.9 | 2.7 | 3.5 | 3.8 |
| | | Adhesive layer | 1.4 | 1.5 | 1.1 | 1.0 | 1.2 | 1.3 | 0.8 | 0.9 | 1.3 | 0.6 | 1.4 |
| | Thermal conductivity (W/mK) | | 12 | 14 | 14 | 11 | 10 | 9 | 8 | 8.4 | 9.3 | 7.9 | 9.2 |
| | Shear strength (MPa) | Stage B | 7 | 5 | 6 | 4 | 8 | 10 | 12 | 6 | 5 | 6 | 6 |
| | | Stage C | 7 | 8 | 10 | 10 | 14 | 16 | 18 | 8 | 9 | 8 | 9 |
| | Dielectric strength voltage (kV) | Stage B | 6 | 5 | 5 | 6 | 8 | 5 | 4 | 5 | 6 | 5 | 5 |
| | | Stage C | 8 | 9 | 12 | 12 | 13 | 10 | 9 | 7 | 8 | 7 | 9 |

| | | | | | | | | | | | | | |
|---|---|---|---|---|---|---|---|---|---|---|---|---|---|
| * Reference Example | | | | | | | | | | | | | |

**Table 3**

| | | | Comparative Example 1 | Comparative Example 2 | Comparative Example 3 | Comparative Example 4 | Comparative Example 5 | Comparative Example 6 |
|---|---|---|---|---|---|---|---|---|
| Resin composition layer | Filler (parts) | AA-18 (18 µm) | 83.29 | 83.29 | 0 | 0 | *83.29* | 0 |
| | | AA-3 (3 µm) | 30.29 | 30.29 | 30.29 | 30.29 | 30.29 | 30.29 |
| | | AA-04 (0.4 µm) | 12.62 | 12.62 | 12.62 | 12.62 | 12.62 | 12.62 |
| | | HP-40 (45 µm) | 0 | 0 | 0 | 0 | 0 | 0 |
| | | FS-3 (76 µm) | 0 | 0 | 46.04 | 46.04 | 0 | 46.04 |
| | Epoxy resin (parts) | MOPOC | 19.39 | 19.39 | 0 | 0 | 19.39 | 0 |
| | | PNAP | 0 | 0 | 5.90 | 5.90 | 0.00 | 5.90 |
| | | Bis-AD | 0 | 0 | 5.90 | 5.90 | 0.00 | 5.90 |
| | Curing agent (parts) | CRN | 11.96 | 11.96 | 8.70 | 8.70 | 11.96 | 8.70 |
| | Coupling agent (parts) | PAM | 0.13 | 0.13 | 0.09 | 0.09 | 0.13 | 0.09 |
| | Catalyst (parts) | TPP | 0.2 | 0.2 | 0.13 | 0.13 | 0.2 | 0.13 |
| | | MEK | 44.77 | 44.77 | 0 | 0 | 44.77 | 0 |
| | Solvent (parts) | CHN | 9.29 | 9.29 | 46.02 | 46.02 | 9.29 | 46.02 |
| | Boron nitride filler content (vol%) | | 0 | 0 | 47 | 47 | 0 | 47 |
| | Filler total content (vol%) | | 74 | 74 | 70 | 70 | 74 | 70 |
| | Thickness at stage B (µm) | | 195 | 195 | 197 | 194 | 113 | 110 |
| Adhesive layer | Resin type | | Modified PAI | Epoxy | Modified PAI | Epoxy | Epoxy | Epoxy |
| | Thickness (µm) | | 6 | 10 | 6 | 10 | 10 | 10 |
| | Adhesive layer | | Both sides | Both sides | Both sides | Both sides | One side | One side |
| Filler embedment | | | No | No | No | No | No | No |
| Properties | Average thickness of total multilayer resin sheet (µm) | | 207 | 215 | 209 | 214 | 123 | 120 |
| | Average thickness of total cured multilayer resin sheet (µm) | | 205 | 208 | 186 | 189 | 121 | 115 |
| | Compression rate (%) | | 1.0 | 3.3 | 11.0 | 11.7 | 1.7 | 4.2 |
| | Arithmetic average surface roughness (µm) | Resin composition layer | 4.2 | 4.2 | 3.9 | 3.9 | 5.8 | 6.4 |
| | | Adhesive layer | 2.1 | 2.0 | 1.9 | 2.5 | 1.7 | 2.4 |
| | Thermal conductivity (W/mK) | | 6.2 | 6.8 | 7.8 | 7.6 | 3.1 | 6.3 |
| | Shear strength (MPa) | Stage B | 6 | 5 | 5 | 5 | 6 | 5 |
| | | Stage C | 10 | 8 | 8 | 7 | 6 | 7 |
| | Dielectric strength voltage (kV) | Stage B | 6 | 6 | 5 | 5 | 6 | 5 |
| | | Stage C | 9 | 9 | 8 | 8 | 9 | 7 |

As is seen from the results, the cured resin sheet laminate including the multilayer resin sheet of the invention exhibits excellent thermal conductivity, adhesion strength and insulation properties.

## Claims

1. A multilayer resin sheet comprising:
a resin composition layer that comprises a thermosetting resin and a filler; and
an adhesive layer that is disposed on at least one surface of the resin composition layer, the adhesive layer having an arithmetic average surface roughness Ra of 1.5 µm or less at a surface that does not face the resin composition layer, wherein
the filler comprises a boron nitride filler,
the boron nitride filler comprises a boron nitride filler having a volume average particle diameter of from 10 µm to 100 µm,
the adhesive layer is disposed on a surface of the resin composition layer that has an arithmetic average surface roughness Ra of from 1.5 µm to 4.0 µm,
the adhesive layer has an average thickness of from 6 µm to 15 µm, and
the resin composition layer comprises the filler of from 40 to 85% by volume in a total solid content of the resin composition layer,
the arithmetic average surface roughness Ra of the adhesive layer and the arithmetic average surface roughness Ra of the resin composition layer prior to providing the adhesive layer being measured with a surface roughness measuring instrument as indicated in the description, and
the volume average particle diameter of the boron nitride filler being measured by laser diffractometry, wherein the measurement is performed with a laser diffraction scattering particle size distribution analyzer using a filler that is separated from the resin composition by extraction with an organic solvent, nitric acid, or aqua regia, and dispersed thoroughly with an ultrasonic wave disperser, measuring the particle size distribution of the dispersion and determining the volume average particle diameter of the filler.

2. The multilayer resin sheet according to claim 1, wherein the resin composition layer comprises, as the thermosetting resin, an epoxy resin monomer and a curing agent.

3. The multilayer resin sheet according to claim 1, wherein a content of the boron nitride filler having a volume average particle diameter of from 10 µm to 100 µm is from 10% by volume
to 60% by volume in a total solid content of the resin composition layer.

4. The multilayer resin sheet according to any one of claims 1 to 3, wherein a compression rate of the multilayer resin sheet is 10% or more, the compression rate being obtained by dividing the thickness of the cured multilayer resin sheet obtained by subjecting a B-stage multilayer resin sheet to a thermal treatment at a temperature of 165°C, a pressure of 10 MPa, a degree of vacuum of ≤ 1 kPa and a treatment time of 3 minutes by the thickness of the B-stage multilayer resin sheet, and subtracting the calculated result from 1.

5. The multilayer resin sheet according to any one of claims 1 to 4, wherein the adhesive layer comprises:
at least one resin selected from the group consisting of an epoxy resin that comprises an acrylic-modified rubber, a modified polyimide resin and a modified polyamideimide resin; and
an alumina filler.

6. A cured multilayer resin sheet that is a thermally-treated product of the multilayer resin sheet according to any one of claims 1 to 5.

7. The cured multilayer resin sheet according to claim 6, wherein the thermosetting resin forms a cured resin having a high-order structure.

8. A resin sheet laminate that comprises:
the multilayer resin sheet according to any one of claims 1 to 5; and
a metal plate or a radiator plate that is disposed on the adhesive layer of the multilayer resin sheet.

9. A cured resin sheet laminate that is a thermally-treated product of the resin sheet laminate according to claim 8.

10. A method of producing the cured resin sheet laminate according to claim 9, the method comprising:
obtaining a resin sheet laminate by disposing the metal plate or the radiator plate on the adhesive layer of the multilayer resin sheet according to any one of claims 1 to 5; and
curing the resin composition layer by applying heat to the resin sheet laminate.

11. A multilayer resin sheet with a metal foil, the multilayer resin sheet comprising:
the multilayer resin sheet according to any one of claims 1 to 5; and
a metal foil that is disposed on the adhesive layer of the multilayer resin sheet.

12. A semiconductor device that comprises a semiconductor element and the cured multilayer resin sheet according to claim 6 or 7 disposed on the semiconductor element.

## Patentansprüche

1. Mehrschichtige Harzfolie, umfassend:
eine Harzzusammensetzungsschicht, die ein wärmehärtendes Harz und einen Füllstoff umfasst, und
eine Klebeschicht, die auf mindestens einer Oberfläche der Harzzusammensetzungsschicht angeordnet ist, wobei die Klebeschicht eine arithmetische mittlere Oberflächenrauheit Ra von 1,5 µm oder weniger auf einer Oberfläche, die der Harzzusammensetzungsschicht nicht gegenüberliegt, aufweist, wobei
der Füllstoff einen Bornitridfüllstoff umfasst,
der Bornitridfüllstoff einen Bornitridfüllstoff mit einem volumengemittelten Partikeldurchmesser von 10 µm bis 100 µm umfasst,
die Klebeschicht auf einer Oberfläche der Harzzusammensetzungsschicht, die eine arithmetische mittlere Oberflächenrauheit Ra von 1,5 µm bis 4,0 µm aufweist, angeordnet ist,
die Klebeschicht eine durchschnittliche Dicke von 6 µm bis 15 µm aufweist und
die Harzzusammensetzungsschicht den Füllstoff zu 40 bis 85 Vol. -% in einem Gesamtfeststoffgehalt der Harzzusammensetzungsschicht umfasst,
wobei die arithmetische mittlere Oberflächenrauheit Ra der Klebeschicht und die arithmetische mittlere Oberflächenrauheit Ra der Harzzusammensetzungsschicht vor dem Bereitstellen der Klebeschicht mit einem Oberflächenrauheitmessgerät wie in der Beschreibung angegeben gemessen werden und
der volumengemittelte Partikeldurchmesser des Bornitridfüllstoffs mittels Laserdiffraktometrie gemessen wird, wobei die Messung mit einem Laser-Diffraktions-Streuungs-Partikelgrößenverteilungsanalysator durch Verwendung eines Füllstoffs, der von der Harzzusammensetzung durch Extraktion mit einem organischen Lösungsmittel, Salpetersäure oder Königswasser getrennt wird und sorgfältig mit einem Ultraschallwellendisperger dispergiert wird, Messen der Partikelgrößenverteilung der Dispersion und Bestimmten des volumengemittelten Partikeldurchmessers des Füllstoffs durchgeführt wird.

2. Mehrschichtige Harzfolie gemäß Anspruch 1, wobei die Harzzusammensetzungsschicht als wärmehärtendes Harz ein Epoxidharzmonomer und ein Härtungsmittel umfasst.

3. Mehrschichtige Harzfolie gemäß Anspruch 1, wobei ein Gehalt des Bornitridfüllstoffs mit einem volumengemittelten Partikeldurchmesser von 10 µm bis 100 µm 10 Vol. -% bis 60 Vol. -% in einem Gesamtfeststoffgehalt in der Harzzusammensetzungsschicht beträgt.

4. Mehrschichtige Harzfolie gemäß irgendeinem der Ansprüche 1 bis 3, wobei eine Kompressionsrate der mehrschichtigen Harzfolie 10 % oder mehr beträgt, wobei die Kompressionsrate durch Dividieren der Dicke der gehärteten mehrschichtigen Harzfolie, die erhalten wird, indem eine mehrschichtige Harzfolie im B-Zustand einer Wärmebehandlung bei einer Temperatur von 165°C, einem Druck von 10 MPa, einem Vakuumgrad von ≤ 1 kPa und einer Behandlungsdauer von 3 Minuten unterzogen wird, durch die Dicke der mehrschichtigen Harzfolie im B-Zustand und Subtrahieren des berechneten Ergebnisses von 1 erhalten wird.

5. Mehrschichtige Harzfolie gemäß irgendeinem der Ansprüche 1 bis 4, wobei die Klebeschicht umfasst:
mindestens ein Harz, ausgewählt aus der Gruppe, bestehend aus einem Epoxidharz, das einen Acrylmodifizierten Kautschuk umfasst, einem modifizierten Polyimidharz und einem modifizierten Polyamidimidharz, und
einen Aluminiumoxidfüllstoff.

6. Gehärtete mehrschichtige Harzfolie, die ein wärmebehandeltes Produkt der mehrschichtigen Harzfolie gemäß irgendeinem der Ansprüche 1 bis 5 ist.

7. Gehärtete mehrschichtige Harzfolie gemäß Anspruch 6, wobei das wärmehärtende Harz ein gehärtetes Harz mit einer Struktur hoher Ordnung bildet.

8. Harzfolienlaminat, das umfasst:
die mehrschichtige Harzfolie gemäß irgendeinem der Ansprüche 1 bis 5 und
eine Metallplatte oder eine Radiatorplatte, die auf der Klebeschicht der mehrschichtigen Harzfolie angeordnet ist.

9. Gehärtetes Harzfolienlaminat, das ein wärmebehandeltes Produkt des Harzfolienlaminats gemäß Anspruch 8 ist.

10. Verfahren zur Herstellung des gehärteten Harzfolienlaminats gemäß Anspruch 9, wobei das Verfahren umfasst:
Erhalten eines Harzfolienlaminats durch Aufbringen der Metallplatte oder der Radiatorplatte auf die Klebeschicht der mehrschichtigen Harzfolie gemäß irgendeinem der Ansprüche 1 bis 5 und
Härten der Harzzusammensetzungsschicht durch Anwendung von Wärme auf das Harzfolienlaminat.

11. Mehrschichtige Harzfolie mit einer Metallfolie, wobei die mehrschichtige Harzfolie umfasst:
die mehrschichtige Harzfolie gemäß irgendeinem der Ansprüche 1 bis 5 und
eine Metallfolie, die auf der Klebeschicht der mehrschichtigen Harzfolie angeordnet ist.

12. Halbleitervorrichtung, die ein Halbleiterelement und die gehärtete mehrschichtige Harzfolie gemäß Anspruch 6 oder 7, angeordnet auf dem Halbleiterelement, umfasst.

## Revendications

1. Feuille de résine multicouche comprenant :
une couche de composition de résine qui comprend une résine thermodurcissable et une charge ; et
une couche adhésive qui est disposée sur au moins une surface de la couche de composition de résine, la couche adhésive présentant une rugosité de surface moyenne arithmétique Ra de 1,5 µm ou moins au niveau d'une surface qui ne fait pas face à la couche de composition de résine, dans laquelle
la charge comprend une charge de nitrure de bore,
la charge de nitrure de bore comprend une charge de nitrure de bore présentant un diamètre de particule moyen en volume de 10 µm à 100 µm,
la couche adhésive est disposée sur une surface de la couche de composition de résine qui présente une rugosité de surface moyenne arithmétique Ra de 1,5 µm à 4,0 µm,
la couche adhésive présente une épaisseur moyenne de 6 µm à 15 µm, et
la couche de composition de résine comprend la charge de 40 à 85 % en volume dans une teneur solide totale de la couche de composition de résine,
la rugosité de surface moyenne arithmétique Ra de la couche adhésive et la rugosité de surface moyenne arithmétique Ra de la couche de composition de résine avant de fournir la couche adhésive étant mesurées avec un instrument de mesure de rugosité de surface comme il est indiqué dans la description, et
le diamètre de particule moyen en volume de la charge de nitrure de bore étant mesuré par diffractométrie laser, dans laquelle la mesure est réalisée avec un analyseur de composition granulométrique par diffraction-diffusion laser en utilisant une charge qui est séparée de la composition de résine par extraction avec un solvant organique, acide nitrique, ou eau régale, et dispersée soigneusement avec un diffuseur d'onde ultrasonique, en mesurant la composition granulométrique de la dispersion et en déterminant le diamètre de particule moyen en volume de la charge.

2. Feuille de résine multicouche selon la revendication 1, dans laquelle la couche de composition de résine comprend, comme résine thermodurcissable, un monomère de résine époxy et un agent durcisseur.

3. Feuille de résine multicouche selon la revendication 1, dans laquelle une teneur de la charge de nitrure de bore présentant un diamètre de particule moyen en volume de 10 µm à 100 µm est de 10 % en volume
à 60 % en volume dans une teneur solide totale de la couche de composition de résine.

4. Feuille de résine multicouche selon l'une quelconque des revendications 1 à 3, dans laquelle un taux de compression de la feuille de résine multicouche est de 10 % ou plus, le taux de compression étant obtenu par division de l'épaisseur de la feuille de résine multicouche durcie obtenue par soumission d'une feuille de résine multicouche d'étape B à un traitement thermique à une température de 165 °C, une pression de 10 MPa, un degré de vide de ≤1 kPa et un temps de traitement de 3 minutes par l'épaisseur de la feuille de résine multicouche d'étape B, et soustraction du résultat calculé de 1.

5. Feuille de résine multicouche selon l'une quelconque des revendications 1 à 4, dans laquelle la couche adhésive comprend :
au moins une résine sélectionnée à partir du groupe constitué par une résine époxy qui comprend un caoutchouc à acrylique modifié, une résine à polyimide modifié et une résine à polyamideimide modifié ; et
une charge d'alumine.

6. Feuille de résine multicouche durcie qui est un produit traité thermiquement de la feuille de résine multicouche selon l'une quelconque des revendications 1 à 5.

7. Feuille de résine multicouche durcie selon la revendication 6, dans laquelle la résine thermodurcissable forme une résine durcie présentant une structure d'ordre élevé.

8. Stratifié de feuille de résine qui comprend :
la feuille de résine multicouche selon l'une quelconque des revendications 1 à 5 ; et
une plaque métallique ou une plaque de radiateur qui est disposée sur la couche adhésive de la feuille de résine multicouche.

9. Stratifié de feuille de résine durcie qui est un produit traité thermiquement du stratifié de feuille de résine selon la revendication 8.

10. Procédé de production du stratifié de feuille de résine durcie selon la revendication 9, le procédé comprenant :
l'obtention d'un stratifié de feuille de résine par disposition de la plaque métallique ou de la plaque de radiateur sur la couche adhésive de la feuille de résine multicouche selon l'une quelconque des revendications 1 à 5 ; et
le durcissement de la couche de composition de résine par application de chaleur au stratifié de feuille de résine.

11. Feuille de résine multicouche avec une feuille métallique, la feuille de résine multicouche comprenant :
la feuille de résine multicouche selon l'une quelconque des revendications 1 à 5 ; et
une feuille métallique qui est disposée sur la couche adhésive de la feuille de résine multicouche.

12. Dispositif à semi-conducteurs qui comprend un élément semi-conducteur et la feuille de résine multicouche durcie selon la revendication 6 ou 7 disposée sur l'élément semi-conducteur.
